(19) Europäisches Patentamt
European Patent Office
Office européen des brevets

(11) EP 2 801 867 A1

(12) **EUROPÄISCHE PATENTANMELDUNG**

(43) Veröffentlichungstag:
**12.11.2014 Patentblatt 2014/46**

(21) Anmeldenummer: **14167146.1**

(22) Anmeldetag: **06.05.2014**

(51) Int Cl.:
*G03H 1/02* (2006.01) *G02B 5/32* (2006.01)
*B32B 7/06* (2006.01) *G03H 1/04* (2006.01)
*G03C 1/825* (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **08.05.2013 EP 13167097**

(71) Anmelder: **Bayer MaterialScience AG**
**51368 Leverkusen (DE)**

(72) Erfinder:
- **Weiser, Marc-Stephan**
**51377 Leverkusen (DE)**
- **Bruder, Friedrich-Karl**
**47802 Krefeld (DE)**
- **Hagen, Rainer**
**51377 Leverkusen (DE)**
- **Walze, Günther**
**50676 Köln (DE)**
- **Rölle, Thomas**
**51381 Leverkusen (DE)**
- **Berneth, Horst**
**51373 Leverkusen (DE)**
- **Hönel, Dennis**
**53909 Zülpich-Wichterich (DE)**
- **Fäcke, Thomas**
**51375 Levekusen (DE)**

(74) Vertreter: **BIP Patents**
**c/o Bayer Intellectual Property GmbH**
**Creative Campus Monheim**
**Alfred-Nobel-Straße 10**
**40789 Monheim (DE)**

(54) **Holografisches Aufzeichnungsmedium mit Anti-Halo-Schicht und Verfahren zu seiner Herstellung**

(57) Die Erfindung betrifft einen Schichtaufbau (100, 200, 300) mit einer Substratschicht (104) und mindestens einem Verbund aus einer Trägerfolie (102) und einer auf der Trägerfolie angeordneten Aufzeichnungsschicht (101), wobei der Schichtaufbau (100, 200, 300) eine vom Verbund aus Trägerfolie (102) und Aufzeichnungsschicht (101) entfernbare Schwarzschicht (103) umfasst, dadurch gekennzeichnet, dass die Aufzeichnungsschicht (101) ein Photopolymer, hergestellt aus einer Photopolymer-Formulierung umfassend eine Polyisocyanat-Komponente, eine isocyanatreaktive Komponente, wenigstens ein Schreibmonomer und wenigstens einen Photoinitiator, ist. Die Erfindung betrifft ferner ein Verfahren zur Erzeugung eines solchen Schichtaufbaus (100, 200, 300)

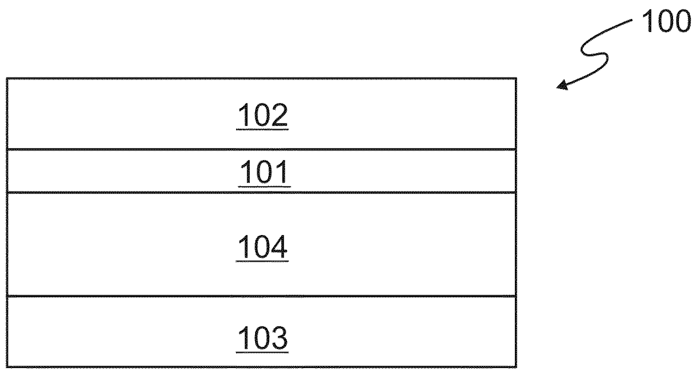


Fig. 1

EP 2 801 867 A1

## Beschreibung

Die vorliegende Erfindung betrifft einen Schichtaufbau mit einer Substratschicht und mindestens einem Verbund aus einer Trägerfolie und einer auf der Trägerfolie angeordneten Aufzeichnungsschicht, wobei der Schichtaufbau eine vom Verbund aus Trägerfolie und Aufzeichnungsschicht entfernbare Schwarzschicht umfasst, sowie ein Verfahren zur Erzeugung eines solchen Schichtaufbaus .

Volumenphasenhologramme, kurz Volumenhologramme, sind holografisch-optische Elemente (HOE), die vielfältige bildgebende und lichtlenkende Funktionalitäten aufweisen können. Sie werden durch Belichtung eines geeigneten Aufzeichnungsmediums in einem holografischen Verfahren hergestellt. Ein spezieller HOE-Typ ist das Transmissionshologramm, dessen Phasengitter einfallendes Licht geeigneter Richtung und Spektralfarbe in Transmission beugen, so dass daraus holografische Diffusoren, Linsen o.ä. hergestellt werden können. Verwendung finden diese z.B. als Schirme in Rückprojektions-Displays, als Ein- oder Auskoppelemente in ebenen Wellenleitern oder als richtungsselektive Lichtlenkelemente in autostereoskopischen Displays. Transmissionshologramme ermöglichen Optiken mit erweiterter Funktionalität, die zugleich kompakt/dünn, leicht und flexibel zu handhaben sind.

Methoden und Apparaturen zur Herstellung von Transmissionshologrammen sind bekannt: So zeigt US 2012/0038959 einen Interferenzaufbau, bei dem Laserstrahlen in Objektstrahl und Referenzstrahl geteilt und mittels entsprechender optischer Bauteile am Ort des Aufzeichnungsmediums zur Interferenz gebracht werden. Die durch Interferenz entstandenen Intensitätsmodulationen erzeugen entsprechende Phasenmodulationen im Volumen des Aufzeichnungsmediums. Das zu holografierende Objekt ist z.B. ein Diffusor, an dem die Laserstrahlen gestreut werden und als Objektwellen auf das Aufzeichnungsmedium treffen. Im Falle anderer zu holografierender Objekte und je nach gewünschter geometrischer Funktion des Hologramms (Rekonstruktionswinkel und Abstrahlcharakteristik) und je nach gewünschtem Rekonstruktions-Farbspektrum sind die Apparaturen anzupassen. Eine abgewandelte Apparatur ist der Einstrahlaufbau. Er wird meist eingesetzt, wenn das Objekt ein Masterhologramm ist, von dem eine Kopie erzeugt werden soll. US 2006/0176533 beschreibt ein Verfahren zum Kopieren von HOEs von einer Masterplatte mittels eines Einstrahlaufbaus. Master und Aufzeichnungsmedium werden dabei in Kontakt gebracht. Der Master, bestehend aus einem Transmissionshologramm, erzeugt die Objektwelle, so dass das ungebeugte transmittierte Laserlicht mit dem gebeugten Licht interferiert und somit in dem Aufzeichnungsmedium eine Kopie des Masterhologramms erzeugt wird.

Die grundsätzlichen Anforderungen an das Aufzeichnungsmedium, das entweder als Master für weitere Kopien oder als Medium für ein Transferhologramm verwendet wird, sind aus der Literatur bekannt ["Practical Holography", by Graham Saxby, IOP Publishing (2003), ISBN 0 7503 0912 1]. Sie leiten sich aus den hohen holografisch-optischen Qualitätsanforderungen ab.

Der Begriff Transferhologramm steht hier und im Folgenden für die Hologrammkopie, die von einem oder mehreren Masterhologrammen erzeugt wurde.

Die Hauptanforderungen an das flächige Aufzeichnungsmaterial, das als Folie oder Beschichtung definiert ist, lauten wie folgt:

- Hohe optische Qualität, geringe Streuung, idealerweise selbst entwickelnd während der holografischen Belichtung, einfache Nachbearbeitung möglichst ohne nasschemische oder thermische Prozesse, gute Langzeitstabilität, gute Umgebungsstabilität, Kompatibilität zu Produktintegrationsschritten.
- Es folgen weitere Anforderungen an holografische Parameter, wie die spektrale Sensitivität, die Linearität im photochemischen oder photophysikalischen Prozess, die Höhe der Brechungsindexmodulation, die spektrale Breite der Hologramme, die laterale Auflösung, eine geringe Neigung zum Überbelichten, und die Möglichkeit, definierte Winkel und Spektralfarben reproduzieren zu können.

Die Hauptanforderungen an das Aufzeichnungsmedium, das als Schichtenverbund definiert ist, lauten wie folgt:

- Mechanisch stabil, d.h. schwingungsfrei, während der holografischen Belichtung. Als Problem sind dunkle Flecken in der Masterhologramm bekannt, die aus verschiedenen Blickrichtungen sichtbar sind. Bekannte Ursache bei Transmissionshologrammen sind Schwingungen des Medium aus der Hologrammebene heraus, die durch mangelnde Stabilität der Schichtensysteme ("Flattern") während der Belichtungsphase entstehen.
- Optisch klare, die Wellenfront erhaltende Trägermaterialien. Ein bekanntes Problem bei doppelbrechenden oder mit Dickenschwankungen versehenen Substraten sind sichtbare dunkle Flecken in der Ebene des Transferhologramms. Durch Doppelbrechung kann die definierte Polarisation der Laserstrahlen (die sog. s-s-Polarisation) lokal verändert werden, so dass neben den Intensitätsmodulationen, die das Hologramm erzeugen, auch Polarisationsmodulationen entstehen. Es fehlt somit Lichtintensität für den Aufbau des holografischen Gitters, dessen Kontrast schwächer wird.
- Vermeidung von Rückreflexen. Manche holografische Filme besitzen eine sog. Anti-Halo-Ausrüstung, z.B. in Form einer Lichthof-Schutzschicht (engl.: anti-halation layer). Das ist eine Zusatzfolie oder -schicht, die als Lichtabsorber

oder Anti-Reflexschicht entweder zwischen der Aufzeichnungsschicht und der rückseitigen Trägerschicht eingebracht bzw. direkt rückseitig aufgebracht ist. Als Rückseite wird die laserabgewandte Seite bei der Belichtung des Transmissionshologramms bezeichnet. An diesen Positionen verhindert sie, dass Streu-und Spiegellichtreflexe von dem Trägermaterial (Folie oder Platte) zurück in die Aufzeichnungsschicht reflektiert werden, und unerwünschte zusätzliche Hologramme, sog. Geisterhologramme, erzeugen. Rückseitenreflexionen können auch einen Lichthof rund um helle holografische Regionen erzeugen. Dem Fachmann ist auch bekannt, dass jegliche Art von Grenzschichtinhomogenitäten oder Lufteinschlüssen zwischen der Aufzeichnungsschicht und Anti-Halo-Schicht, bzw. rückseitigem Substrat und Anti-Halo-Schicht zu Newton-Ringen oder -Streifen im Hologramm führen wird. Daraus ergibt sich die Anforderung, dass die Anti-Halo-Schicht bündig mit ihrer angrenzenden Vorderschicht abschließen muss. Eine weitere Anforderung an die Anti-Halo-Schicht, die zwingend erfüllt sein muss, damit das Hologramm verwendet werden kann, ist die Möglichkeit, die Anti-Halo-Schicht nach der holografischen Belichtung und den ggf. anschließenden Entwicklungs-/Fixierschritten, vollständig entfernen zu können.

Für Transmissionshologramme in der industriellen Anwendung sind holografische Aufzeichnungsmaterialien bevorzugt, die als Folienverbund vorliegen und damit in Massenherstellungsprozesse, wie die Rolle-zu-Rolle Verarbeitung, verwendet werden können. Dazu gehören Silberhalogenid-Emulsionen, gehärtete Dichromat-Gelatine und Photopolymere. Photopolymere gelten als besonders bevorzugt, weil sie sich als lagerstabiler erwiesen und im Gegensatz zum Dichromat und dem Silberhalogenid ohne nasschemische Verarbeitungsschritte auskommen, die bei diesen Materialien der Entwicklung und Fixierung dienen. Die Nasschemie bedeutet einen zusätzlichen Verarbeitungsschritt bei der Hologrammherstellung und verschlechtert in der Regel die Qualität des Hologramms als Folge von Quellung und anschließendem Materialschrumpf. Photopolymere wurden in den vergangenen Jahrzehnten entwickelt. Hierzu wird exemplarisch auf US 4,942,112, US 5,759,721, EP 1 510 862, EP 1 231 511, EP 211 615, WO 2003/036389 A, sowie US 2002/142227 verwiesen. Der Stand der Technik weist selbstentwickelnde Photopolymerfilme aus, die für die Herstellung von Volumenhologrammen geeignet sind, wie beispielsweise in WO 2010/037515.

Nach dem Stand der Technik sind Anti-Halo-Schichten in der Volumenholografie bekannt. US 5,985,490 beschreibt einen Reflexionshologramm-Master mit Anti-Halo-System und seine Herstellung: Das Medium weist einen Neutraldichtefilter angrenzend an die Masterplatte auf, der in Verbindung mit einer Anti-Reflexbeschichtung seine Funktion erfüllt. Der Träger des Anti-Halo-Systems ist ein 0,5 bis 1,5 mm dickes Glas. Der Kontakt zu der Aufzeichnungsschicht wird über eine elastische Polymerschicht, die als Spannungsaufnehmer und chemische Barriere dient, sowie über eine Kontaktflüssigkeit, die die Brechungsindexanpassung bewirkt. Würde man dieses Anti-Halo-System für die Herstellung von Transmissionshologrammen verwenden, müsste es vom Hologramm trennbar sein. Neutraldichteglas und Antireflexbeschichtung sind hochwertig und teuer, und sollten daher wiederverwendet werden. Ein dünnes Glas ist bruchempfindlich und die beschriebenen Oberflächen kratzempfindlich, was die Entwicklung eines technischen Verfahrens zum Trennen und Verbinden von Hologramm und Anti-Halo-System erschwert. Darüber hinaus erfordert das zur Brechungsindexanpassung verwendete Flüssigmaterial weitere Prozessschritte, die die Vorrichtung zur Herstellung des Hologramms komplexer werden lassen. Hinzu kommt das Flüssigkeiten zur Brechungsindexanpassung in der Regel lange Verweildauern bis zum Start der holografischen Belichtung erfordern, da sonst durch Flüssigkeitsbewegungen das Interferenzgitter während der holografischen Belichtung nicht stabil ist. Die Verwendung ist daher für ein wirtschaftlich lohnendes Aufnahmeverfahren nicht geeignet.

Der vorliegenden Erfindung lag daher die Aufgabe zugrunde, einen Schichtaufbau der eingangs genannten Art zur Verfügung zu stellen, der den oben stehenden Anforderungen besser genügt und bei dem störende Reflexionen, die zu Fehlern in der Aufzeichnungsschicht führen könnten, bei der Belichtung weitestgehend unterbunden werden.

Diese Aufgabe wird bei einen Schichtaufbau der eingangs genannten Art dadurch gelöst, dass die Aufzeichnungsschicht ein Photopolymer, hergestellt aus einer Photopolymer-Formulierung umfassend eine Polyisocyanat-Komponente, eine isocyanatreaktive Komponente, wenigstens ein Schreibmonomer und wenigstens einen Photoinitiator, ist.

Bei dem erfindungsgemäßen Schichtaufbau ist die Aufzeichnungsschicht vorzugsweise geeignet, um darin Hologramme auszubilden und/ oder es ist in der Aufzeichnungsschicht wenigstens ein Hologramm ausgebildet, wobei das Hologramm insbesondere ein Volumenhologramm ist, ganz besonders bevorzugt ein Transmissionsvolumenhologramm.

Es kann ferner vorgesehen sein, dass die Schwarzschicht auf einer Seite der Substratschicht und der Verbund aus Trägerfolie und Aufzeichnungsschicht auf der anderen Seite der Substratschicht mit der Aufzeichnungsschicht zur Substratschicht hin angeordnet ist, wobei die Schichten insbesondere in der Reihenfolge Schwarzschicht, Substratschicht, Aufzeichnungsschicht und Trägerfolie unmittelbar aufeinander angeordnet sind.

Bei einem hierzu alternativen Schichtaufbau kann die Schwarzschicht auf der der Substratschicht abgewandten Fläche der Trägerfolie und die Aufzeichnungsschicht auf der der Substratschicht zugewandten Fläche der Trägerfolie angeordnet sein, wobei die Schichten insbesondere in der Reihenfolge Substratschicht, Aufzeichnungsschicht, Trägerfolie und Schwarzschicht unmittelbar aufeinander angeordnet sind.

In einer weiteren alternativen Ausgestaltung des erfindungsgemäßen Schichtaufbaus kann die Schwarzschicht

auf der der Substratschicht abgewandten Fläche der Aufzeichnungsschicht und die Trägerfolie auf der der Substratschicht zugewandten Fläche der Aufzeichnungsschicht angeordnet sein, wobei die Schichten insbesondere in der Reihenfolge Substratschicht, Trägerfolie, Aufzeichnungsschicht und Schwarzschicht unmittelbar aufeinander angeordnet sind.

Gemäß einer bevorzugten Ausführungsform des erfindungsgemäßen Schichtaufbaus ist die Substratschicht transparent und insbesondere ausgewählt aus Glas und thermoplastischen Kunststoffen mit einer hemisphärischen Transmission gemäß ASTM E 1348 nach D65/10° von > 80%, bevorzugt > 89%, sowie einem Haze gemäß ASTM D 1003 von < 0,5%, bevorzugt < 0,1%.

Weiter bevorzugt ist es, dass die Aufzeichnungsschicht ausgewählt ist aus einem volumenholografischen Aufzeichnungsmaterial. Dabei handelt es sich beispielsweise um ein Photopolymer, besonders bevorzugt ein solches hergestellt aus einer Photopolymer-Formulierung umfassend eine Polyisocyanat-Komponente, eine isocyanatreaktive Komponente, wenigstens ein Schreibmonomer und wenigstens einen Photoinitiator. Derartige Systeme sind beispielsweise beschrieben in WO-A 2011/054797 und WO 2011/067057, deren Inhalt hiermit vollständig in die vorliegende Anmeldung einbezogen wird.

Der erfindungsgemäße Schichtaufbau umfasst eine Schwarzschicht. Die Schwarzschicht kann ausgewählt sein aus schwarzen Klebebändern, schwarzen Kaschierfolien, schwarz gefärbten Schmelzklebstoffen, schwarz gefärbten Schmelzklebstofffolien und Schwarzlacken, um nur einige Möglichkeiten aufzuzeigen.

Bevorzugt ist es, dass die Schwarzschicht frei von lichtstreuenden Partikeln ist. Dies ist vorteilhaft, weil hierdurch neben der eigentlichen Reflexion sichtbaren Lichts auch die Entstehung von Streustrahlung beim Belichten weitestgehend unterbunden wird, die ebenfalls zu Ungenauigkeiten bei der Belichtung führen könnte.

Gemäß einer besonders bevorzugten Ausführungsform des erfindungsgemäßen Schichtaufbaus weist die Schwarzschicht einen Absorptionsquotienten für die Reflexionsmessung von $Q \leq 0{,}70$ auf, wobei der Absorptionsquotient Q das Verhältnis der Reflektion einer Glasplatte mit Schwarzschicht im Vergleich zu derselben Glasplatte ohne Schwarzschicht bei Beleuchtung von der transparenten Glasseite aus mit einer Wellenlänge von 532 nm beschreibt, bevorzugt $Q \leq 0{,}55$ und besonders bevorzugt $Q \leq 0{,}52$.

Im Rahmen der vorliegenden Erfindung kann die Trägerfolie aus einer Vielzahl möglicher Materialien ausgewählt sein, vorzugsweise aus transparenten Folien.

Die Trägerfolie sowie unabhängig hiervon die Folie des schwarzen Klebebandes kann vorzugsweise ausgewählt sein aus Folien auf Basis von Polycarbonat (PC), Polyethylenterephthalat (PET), Polybutylenterephthalat (PBT), Polyethylen, Polypropylen, Celluloseacetate, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral, Polydicyclopentadien, sowie deren Mischungen und/ oder Laminaten. Besonders bevorzugt sind Folien auf Basis von Polycarbonat, Polyethylenterephthalat, Polyamid, Cellulosetriacetat sowie deren Mischungen und/ oder Laminaten. Bevorzugte Laminate sind Duplex- und Triplexfolien aufgebaut nach einem der Schemata A/B, A/B/A oder A/B/C. Besonders bevorzugt sind PC/PET, PET/PC/PET und PC/TPU (TPU = Thermoplastisches Polyurethan).

Ein weiterer Gegenstand der vorliegenden Erfindung betrifft ein Verfahren zur Erzeugung des erfindungsgemäßen Schichtaufbaus, umfassend die Schritte:

- Bereitstellen der Substratschicht,
- Erzeugung der Verbundes durch Aufbringen der Aufzeichnungsschicht auf die Trägerfolie,

wobei das Verfahren dadurch gekennzeichnet ist,
dass die Schwarzschicht auf der dem Verbund abgewandten Fläche der Substratschicht und die Aufzeichnungsschicht auf der der Substratschicht zugewandten Fläche der Trägerfolie angeordnet wird, wobei die Schichten insbesondere in der Reihenfolge Schwarzschicht, Substratschicht, Aufzeichnungsschicht und Trägerfolie unmittelbar aufeinander angeordnet werden, oder
dass die Schwarzschicht auf der der Substratschicht abgewandten Fläche der Trägerfolie und die Aufzeichnungsschicht auf der der Substratschicht zugewandten Fläche der Trägerfolie angeordnet wird, wobei die Schichten insbesondere in der Reihenfolge Substratschicht, Aufzeichnungsschicht, Trägerfolie und Schwarzschicht unmittelbar aufeinander angeordnet werden, oder
dass die Schwarzschicht auf der der Substratschicht abgewandten Fläche der Aufzeichnungsschicht und die Trägerfolie auf der der Substratschicht zugewandten Fläche der Aufzeichnungsschicht angeordnet ist, wobei die Schichten insbesondere in der Reihenfolge Substratschicht, Trägerfolie, Aufzeichnungsschicht und Schwarzschicht unmittelbar aufeinander angeordnet sind.

Nach einer weiteren Ausführungsform des erfindungsgemäßen Verfahrens wird in der Aufzeichnungsschicht durch Belichtung zumindest ein Hologramm erzeugt, insbesondere ein Volumenhologramm, ganz besonders bevorzugt ein Transmissions-Volumenhologramm, im Folgenden verkürzt als Transmissionshologramm bezeichnet. Hierbei kann

weiter vorgesehen sein, dass nach der Erzeugung des Hologramms der Verbund aus Aufzeichnungsschicht und Trägerfolie von der Substratschicht abgelöst und/ oder die Schwarzschicht entfernt wird.

Ein weiterer Gegenstand der vorliegenden Erfindung betrifft einen Verbund aus einer Aufzeichnungsschicht mit zumindest einem einbelichteten Hologramm und einer Trägerfolie, erhältlich nach dem vorstehend beschriebenen Verfahren.

Im erfindungsgemäßen Schichtaufbau kann als Aufzeichnungsschicht im Prinzip jedes beliebige holografische Material verwendet werden. Dies können beispielsweise Silberhalogenid, Dichromatgelatine, jedes beliebige Photopolymer oder andere sein. Bevorzugt sind Photopolymere. Geeignete und bevorzugte Photopolymer-Formulierungen für die Herstellung der Aufzeichnungsschicht sind dem Fachmann bekannt und beispielsweise in WO-A 2011/054797 und WO 2011/067057 beschrieben. Bevorzugt handelt es sich bei der Photopolymer-Formulierung für die Herstellung der Aufzeichnungsschicht um eine solche umfassend eine Polyisocyanat-Komponente a), eine isocyanatreaktive Komponente b), wenigstens ein Schreibmonomer c) und wenigstens einen Photoinitiator d).

Die Polyisocyanat-Komponente a) umfasst wenigstens eine organische Verbindung, die wenigstens zwei NCO-Gruppen aufweist. Als Polyisocyanat können alle dem Fachmann an sich bekannten Verbindungen oder deren Mischungen eingesetzt werden. Diese Verbindungen können auf aromatischer, araliphatischer, aliphatischer oder cycloaliphatischer Basis sein. In untergeordneten Mengen kann die Polyisocyanat-Komponente a) auch Monoisocyanate, d.h. organische Verbindungen mit einer NCO-Gruppe, und / oder ungesättigte Gruppen enthaltende Polyisocyanate umfassen.

Beispiele für geeignete Polyisocyanate sind Butylendiisocyanat, Hexamethylendiisocyanat (HDI), 2,2,4-Trimethylhexamethylendiisocyanat und dessen Isomere (TMDI), Isophorondiisocyanat (IPDI), 1,8-Diisocyanato-4-(isocyanatomethyl)-octan, die isomeren Bis-(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und / oder 2,6-Toluylendiisocyanat, 1,5-Naphthylendiisocyanat, 2,4'- und / oder 4,4'-Diphenylmethandiisocyanat, Triphenylmethan-4,4',4"-triisocyanat oder beliebige Mischungen der vorgenannten Verbindungen.

Monomere Di- oder Triisocyanate mit Urethan-, Harnstoff , Carbodiimid-, Acylharnstoff, Isocyanurat-, Allophanat-, Biuret-, Oxadiazintrion-, Uretdion- und/oder Iminooxadiazindionstrukturen können ebenfalls verwendet werden.

Bevorzugt sind Polyisocyanate auf Basis aliphatischer und / oder cycloaliphatischer Di- oder Triisocyanate. Besonders bevorzugt handelt es sich bei den Polyisocyanaten um di- oder oligomerisierte aliphatische und / oder cycloaliphatische Di- oder Triisocyanate. Ganz besonders bevorzugte Polyisocyanate sind Isocyanurate, Uretdione und / oder Iminooxadiazindione basierend auf HDI, TMDI, 1,8-Diisocyanato-4-(isocyanatomethyl)-octan oder deren Mischungen.

Die Polyisocyanat-Komponente a) kann auch NCO-funktionelle Prepolymere umfassen oder daraus bestehen. Die Prepolymere können Urethan-, Allophanat-, Biuret- und / oder Amidgruppen aufweisen. Derartige Prepolymere sind beispielsweise durch Umsetzung von Polyisocyanaten a1) mit isocyanatreaktiven Verbindungen a2) erhältlich.

Als Polyisocyanate a1) eignen sich alle bekannten aliphatischen, cycloaliphatischen, aromatischen oder araliphatischen Di- und Triisocyanat. Daneben können auch die bekannten höhermolekularen Folgeprodukte monomerer Di- und / oder Triisocyanate mit Urethan-, Harnstoff , Carbodiimid-, Acylharnstoff, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Polyisocyanat a1) eingesetzt werden können, sind Butylendiisocyanat, Hexamethylendiisocyanat, Isophorondiisocyanat, Trimethylhexamethylen-diisocyanat (TMDI), 1,8-Diisocyanato-4-(isocyanatomethyl)-octan, Isocyanatomethyl-1,8-octandiisocyanat (TIN), 2,4- und / oder 2,6-Toluendiisocyanat.

Als isocyanatreaktive Verbindungen a2) können bevorzugt OH-funktionelle Verbindungen verwendet werden. Dabei kann es sich insbesondere um Polyole handeln. Ganz besonders bevorzugt können als isocyanatreaktive Verbindung a2) die weiter unten beschriebenen Polyole der Komponente b) verwendet werden.

Es ist ebenfalls möglich, als isocyanatreaktive Verbindungen a2) Amine einzusetzen. Beispiele geeigneter Amine sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere, insbesondere mit zahlenmittleren Molmassen bis 10000 g/Mol. Mischungen der vorgenannten Amine können ebenfalls verwendet werden.

Bevorzugt ist auch, wenn die isocyanatreaktiven Verbindungen a2) eine zahlenmittlere Molmasse von $\geq$ 200 und $\leq$ 10000 g/Mol, weiter bevorzugt $\geq$ 500 und $\leq$ 8500 g/Mol und ganz besonders bevorzugt > 1000 und $\leq$ 8200 g/Mol aufweisen.

Die Prepolymere der Polyisocyanat-Komponente a) können insbesondere einen Restgehalt an freiem monomerem Isocyanat < 1 Gew.-%, besonders bevorzugt < 0,5 Gew.-% und ganz besonders bevorzugt < 0,2 Gew.-% aufweisen.

Die Polyisocyanat-Komponente a) kann auch Mischungen der vorgenannten Polyisocyanate und Prepolymere

umfassen.

Es ist gegebenenfalls auch möglich, dass die Polyisocyanat-Komponente a) anteilsmäßig Polyisocyanate enthält, die teilweise mit isocyanat-reaktiven, ethylenisch ungesättigten Verbindungen umgesetzt sind. Bevorzugt werden hierbei als isocyanat-reaktive, ethylenisch ungesättigte Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt. Besonders bevorzugt sind Acrylate und Methacrylate mit mindestens einer isocyanatreaktiven Gruppe.

Der Anteil der Polyisocyanate in der Polyisocyanat-Komponente a), der teilweise mit isocyanat-reaktiven, ethylenisch ungesättigten Verbindungen umgesetzt ist, kann 0 bis 99 Gew.-%, bevorzugt 0 bis 50 Gew.-%, besonders bevorzugt 0 bis 25 Gew.-% und ganz besonders bevorzugt 0 bis 15 Gew.-% betragen.

Es ist gegebenenfalls auch möglich, dass die Polyisocyanat-Komponente a) vollständig oder anteilsmäßig Polyisocyanate enthält, die ganz oder teilweise mit aus der Beschichtungstechnologie bekannten Blockierungsmitteln umgesetzt sind. Beispiel für Blockierungsmittel sind Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, $\varepsilon$-Caprolactam, N-tert.-Butyl-benzylamin, Cyclopentanoncarboxyethylester oder deren Mischungen.

Besonders bevorzugt ist, wenn die Polyisocyanat-Komponente a) ein aliphatisches Polyisocyanat oder ein aliphatisches Prepolymer und bevorzugt ein aliphatisches Polyisocyanat oder aliphatisches Prepolymer mit primären NCO-Gruppen umfasst oder daraus besteht.

Die isocyanatreaktive Komponente b) umfasst wenigstens eine organische Verbindung, die wenigstens zwei isocyanatreaktive Gruppen aufweist (isocyanatreaktive Verbindung). Im Rahmen der vorliegenden Erfindung werden als isocyanatreaktive Gruppen Hydroxy-, Amino- oder Thiogruppen angesehen.

Als isocyanatreaktive Komponente können alle Systeme eingesetzt werden, die im Mittel wenigstens 1,5 und bevorzugt mindestens 2, besonders bevorzugt 2 bis 3 isocyanatreaktive Gruppen aufweisen.

Geeignete isocyanatreaktive Verbindungen sind beispielsweise Polyester-, Polyether-, Polycarbonat-, Poly(meth)acrylat- und / oder Polyurethanpolyole.

Besonders geeignete Polyesterpolyole sind beispielsweise lineare oder verzweigte Polyesterpolyole, die aus aliphatischen, cycloaliphatischen oder aromatischen Di- bzw. Polycarbonsäuren bzw. ihren Anhydriden durch Umsetzung mit mehrwertigen Alkoholen einer OH-Funktionalität $\geq 2$ erhältlich sind.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren. Diese können bevorzugt durch Anlagerung von Lactonen bzw. Lactongemischen wie Butyrolacton, $\varepsilon$-Caprolacton und / oder Methyl-$\varepsilon$-caprolacton an hydroxyfunktionelle Verbindungen wie mehrwertige Alkohole einer OH-Funktionalität $\geq 2$, beispielsweise der vorstehend genannten Art, erhalten werden.

Die Polyesterpolyole haben bevorzugt zahlenmittlere Molmassen von $\geq 400$ und $\leq 4000$ g/Mol, besonders bevorzugt von $\geq 500$ und $\leq 2000$ g/Mol.

Die OH-Funktionalität der Polyesterpolyole beträgt bevorzugt 1,5 bis 3,5, besonders bevorzugt 1,8 bis 3,0.

Beispiele zur Herstellung der Polyester besonders geeigneter Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder Mischungen daraus.

Besonders zur Herstellung der Polyester geeignete Alkohole sind beispielsweise Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder Mischungen daraus.

Geeignete Polycarbonatpolyole sind in an sich bekannter Weise durch Umsetzung von organischen Carbonaten oder Phosgen mit Diolen oder Diol-Mischungen zugänglich.

Hierfür geeignete organische Carbonate sind beispielsweise Dimethyl-, Diethyl- und Diphenylcarbonat.

Geeignete mehrwertige Alkohole umfassen die oben im Rahmen der Diskussion der Polyesterpolyole genannten mehrwertigen Alkoholen einer OH-Funktionalität $\geq 2$. Bevorzugt können 1,4-Butandiol, 1,6-Hexandiol und / oder 3-Methylpentandiol eingesetzt werden.

Polyesterpolyole können auch zu Polycarbonatpolyolen umgearbeitet werden. Besonders bevorzugt werden bei der Umsetzung der genannten Alkohole zu Polycarbonatpolyolen Dimethyl- oder Diethylcarbonat eingesetzt.

Die Polycarbonatpolyole haben bevorzugt zahlenmittlere Molmassen von $\geq 400$ und $\leq 4000$ g/Mol, besonders bevorzugt von $\geq 500$ und $\leq 2000$ g/Mol.

Die OH-Funktionalität der Polycarbonatpolyole beträgt bevorzugt 1,8 bis 3,2, besonders bevorzugt 1,9 bis 3,0.

Geeignete Polyetherpolyole sind gegebenenfalls blockweise aufgebaute Polyadditionsprodukte cyclischer

Ether an OH- oder NH-funktionelle Startermoleküle. Geeignete cyclische Ether sind beispielsweise Styroloxide, Ethylenoxid, Propylenoxid, Tetrahydrofuran, Butylenoxid, Epichlorhydrin, sowie deren beliebige Mischungen. Als Startermoleküle können die oben im Rahmen der Diskussion der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art, die ausschließlich auf Propylenoxid basieren. Bevorzugt sind ebenfalls Polyetherpolyole der vorgenannten Art, die statistische Copolymere oder Block-Copolymere, basierend auf Propylenoxid mit weiteren 1-Alkylenoxiden, sind, wobei der 1-Alykenoxidanteil insbesondere nicht höher als 80 Gew.-% ist. Ganz besonders bevorzugt sind Propylenoxid-Homopolymere sowie statistische Copolymere oder Block-Copolymere, die Oxyethylen-, Oxypropylen- und / oder Oxybutyleneinheiten aufweisen, wobei der Anteil der Oxypropyleneinheiten bezogen auf die Gesamtmenge aller Oxyethylen-, Oxypropylen- und Oxybutyleneinheiten insbesondere ≥ 20 Gew.-%, bevorzugt ≥ 45 Gew.-% ist. Oxypropylen- und Oxybutylen umfasst hierbei alle linearen und verzweigten $C_3$- und $C_4$-Isomere.

Die Polyetherpolyole haben bevorzugt zahlenmittlere Molmassen von ≥ 250 und ≤ 10000 g/Mol, besonders bevorzugt von ≥ 500 und ≤ 8500 g/Mol und ganz besonders bevorzugt von ≥ 600 und ≤ 4500 g/Mol. Ihre OH-Funktionalität beträgt bevorzugt 1,5 bis 4,0 und besonders bevorzugt 1,8 bis 3,1.

Weitere bevorzugte Polyetherpolyole bestehen aus einer isocyanatreaktiven Komponente umfassend hydroxyfunktionelle Multiblockcopolymere des Typs $Y(X_i\text{-}H)_n$ mit i = 1 bis 10 und n = 2 bis 8, wobei die Segmente $X_i$ jeweils aus Oxyalkyleneinheiten der Formel (I)

$$-CH_2-CH(R)-O- \qquad (I)$$

aufgebaut sind, in der R ein Alkyl- oder ein Arylrest, ist, der auch substituiert oder durch Heteroatome (wie Ethersauerstoffe) unterbrochen sein kann oder Wasserstoff und Y der zugrundeliegende Starter ist.

Der Rest R kann bevorzugt ein Wasserstoff-, Methyl-, Butyl-, Hexyl-, Octyl- oder ein ethergruppenhaltiger Alkylrest sein. Bevorzugte ethergruppenhaltiger Alkylreste basieren auf Oxyalkyleneinheiten.

Bevorzugt ist n eine ganze Zahl von 2 bis 6, besonders bevorzugt 2 oder 3 und ganz besonders bevorzugt gleich 2.

Bevorzugt ist ebenfalls, wenn i eine ganze Zahl von 1 bis 6, besonders bevorzugt von 1 bis 3 und ganz besonders bevorzugt gleich 1 ist.

Weiter bevorzugt ist, wenn der Anteil der Segmente X;, bezogen auf die Gesamtmenge der Segmente Xi und Y, > 50 Gew.-% und bevorzugt ≥ 66 Gew.-% ist.

Bevorzugt ist auch, wenn der Anteil der Segmente Y, bezogen auf die Gesamtmenge der Segmente $X_i$ und Y, < 50 Gew.-% und bevorzugt < 34 Gew.-% ist.

Die Multiblockcopolymere $Y(X_i\text{-}H)_n$ haben bevorzugt zahlenmittlere Molekulargewichte von > 1200 g/Mol, besonders bevorzugt > 1950 g/Mol, jedoch bevorzugt < 12000 g/Mol, besonders bevorzugt < 8000 g/Mol.

Die Blöcke X; können Homopolymere sein, die ausschließlich aus gleichen Oxyalkylen-Wiederholungseinheiten bestehen. Sie können auch statistisch aus verschiedenen Oxyalkyleneinheiten oder ihrerseits blockweise aus verschiedenen Oxyalkyleneinheiten aufgebaut sein.

Bevorzugte basieren die Segmente X; ausschließlich auf Propylenoxid oder statistischen oder blockweisen Mischungen von Propylenoxid mit weiteren 1-Alkylenoxiden, wobei der Anteil an weiteren 1-Alykenoxiden bevorzugt nicht > 80 Gew.-% ist.

Besonders bevorzugte Segmente X; sind Propylenoxid-Homopolymere sowie statistische Copolymere oder Block-Copolymere, die Oxyethylen- und / oder Oxypropyleneinheiten aufweisen. Ganz besonders bevorzugt beträgt in diesem Fall der Anteil der Oxypropyleneinheiten, bezogen auf die Gesamtmenge aller Oxyethylen- und Oxypropyleneinheiten, ≥ 20 Gew.-% und noch weiter bevorzugt ≥ 40 Gew.-%.

Die Blöcke X; können durch ringöffnende Polymerisation der vorstehend beschriebenen Alkylenoxide auf einen n-fach hydroxy- oder aminofunktionellen Starter $Y(H)_n$ aufaddiert werden.

Der Starter $Y(H)_n$ kann aus di- und / oder höher hydroxyfunktionellen Polymerstrukturen auf Basis cyclischer Ether oder aus di- und / oder höher hydroxyfunktionellen Polycarbonat-, Polyester-, Poly(meth)acrylat-, Epoxydharz- und / oder Polyurethanstruktureinheiten oder entsprechenden Hybriden bestehen.

Beispiele für geeignete Starter $Y(H)_n$ sind die oben genannten Polyester-, Polycarbonat- und Polyetherpolyole.

Die Polyesterpolyole haben bevorzugt zahlenmittlere Molmassen von 200 bis 2000 g/Mol, besonders bevorzugt von 400 bis 1400 g/Mol.

Die Polycarbonatpolyole haben bevorzugt zahlenmittlere Molmassen von 400 bis 2000 g/Mol, besonders bevorzugt von 500 bis 1400 g/Mol und ganz besonders bevorzugt von 650 bis 1000 g/Mol.

Die Polyetherpolyole haben bevorzugt zahlenmittlere Molmassen von 200 bis 2000 g/Mol, besonders bevorzugt von 400 bis 1400 g/Mol und ganz besonders bevorzugt von 650 bis 1000 g/Mol.

Besonders bevorzugte Starter $Y(H)_n$ sind insbesondere difunktionelle Polymere des Tetrahydrofuran, insbesondere difunktionelle aliphatische Polycarbonatpolyole und Polyesterpolyole sowie Polymere des ε-Caprolacton insbesondere mit zahlenmittleren Molmassen < 3100 g/Mol, bevorzugt ≥ 500 g/mol und ≤ 2100 g/mol.

Weitere Beispiele geeigneter Polyether und Verfahren zu deren Herstellung sind in der EP 2 172 503 A1 beschrieben, auf deren diesbezügliche Offenbarung hiermit Bezug genommen wird.

Bei einer weiteren bevorzugten Ausführungsform ist vorgesehen, dass das Schreibmonomer c) wenigstens ein mono- und / oder ein multifunktionales Schreibmonomer umfasst, wobei es sich insbesondere um mono- und multifunktionelle Acrylat-Schreibmonomere handeln kann. Besonders bevorzugt kann das Schreibmonomer wenigstens ein monofunktionelles und ein multifunktionelles Urethan(meth)acrylat umfassen.

Bei den Acrylat-Schreibmonomeren kann es sich insbesondere um Verbindungen der allgemeinen Formel (II)

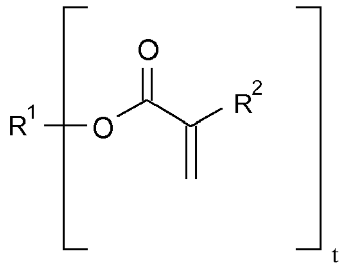

(II)

handeln, bei denen t≥1 und t≤4 ist und $R^1$ ein linearer, verzweigter, cyclischer oder heterocyclischer unsubstituierter oder gegebenenfalls auch mit Heteroatomen substituierter organischer Rest und/oder $R^2$ Wasserstoff, ein linearer, verzweigter, cyclischer oder heterocyclischer unsubstituierter oder gegebenenfalls auch mit Heteroatomen substituierter organischer Rest ist. Besonders bevorzugt ist $R^2$ Wasserstoff oder Methyl und/oder $R^1$ ein linearer, verzweigter, cyclischer oder heterocyclischer unsubstituierter oder gegebenenfalls auch mit Heteroatomen substituierter organischer Rest.

Ebenso ist es möglich, dass weitere ungesättigte Verbindungen wie α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure zugesetzt werden. Bevorzugt sind aber Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate, um nur eine Auswahl verwendbarer Acrylate und Methacrylate zu nennen.

Selbstverständlich können als Acrylate auch Urethanacrylate verwendet werden. Unter Urethanacrylaten versteht man Verbindungen mit mindestens einer Acrylsäureestergruppe, die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanat-funktionelle Verbindungen sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, m-Methylthiophenylisocyanat, Triphenylmethan-4,4',4"-triisocyanat und Tris(p-isocyanatophenyl)thiophosphat oder deren Derivate mit Urethan-, Harnstoff , Carbodiimid-, Acylharnstoff, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise Verbindungen in Betracht wie 2-Hydroxyethyl(meth)acrylat, Polyethylenoxid-mono(meth)acrylate, Polypropylenoxidmono(meth)acrylate, Polyalkylenoxidmono-(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate.

Darüber hinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und m-Methylthiophenylisocyanat mit alkoholfunktionellen Acrylaten wie Hydroxyethyl(meth)acrylat, Hydroxypropyl(meth)acrylat und Hydroxybutyl(meth)acrylat.

Besonders bevorzugt ist eine Kombination aus Komponenten a) und b) bei der Herstellung der Matrixpolymere bestehend aus Additionsprodukten von Butyrolacton, e-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Ganz besonders bevorzugt sind Additionsprodukte von e-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.

Gemäß einer weiteren bevorzugten Ausführungsform ist vorgesehen, dass die Photopolymer-Formulierung zusätzlich Urethane als Additive enthält, wobei die Urethane insbesondere mit wenigstens einem Fluoratom substituiert sein können.

Bevorzugt können die Urethane die allgemeine Formel (III)

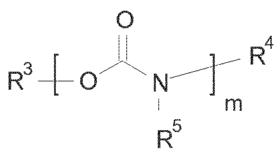

(III)

haben, in der m≥1 und m≤8 ist und $R^3$ ein linearer, verzweigter, cyclischer oder heterocyclischer unsubstituierter oder gegebenenfalls auch mit Heteroatomen substituierter organischer Rest und/oder $R^4$, $R^5$ unabhängig voneinander Wasserstoff sind, wobei bevorzugt mindestens einer der Reste $R^3$, $R^4$, $R^5$ mit wenigstens einem Fluoratom substituiert ist und besonders bevorzugt $R^3$ ein organischer Rest mit mindestens einem Fluoratom ist. Besonders bevorzugt ist $R^5$ ein linearer, verzweigter, cyclischer oder heterocyclischer unsubstituierter oder gegebenenfalls auch mit Heteroatomen wie beispielsweise Fluor substituierter organischer Rest.

Die eingesetzten Photoinitiatoren d) sind üblicherweise durch aktinische Strahlung aktivierbare Verbindungen, die eine Polymerisation der entsprechenden Gruppen auslösen können.

Geeignete Photoinitiatoren d) sind üblicherweise durch aktinische Strahlung aktivierbare Verbindungen, die eine Polymerisation der entsprechenden Gruppen auslösen können. Bei den Photoinitiatoren kann zwischen unimolekularen (Typ I) und bimolekularen (Typ II) Initiatoren unterschieden werden. Des Weiteren werden sie je nach ihrer chemischen Natur in Photoinitiatoren für radikalische, anionische, kationische oder gemischte Art der Polymerisation

unterschieden, hier zu existiert ein breiter Stand der Technik.

Typ I-Photoinitiatoren (Norrish-Typ-I) für die radikalische Photopolymerisation bilden beim Bestrahlen durch eine unimolekulare Bindungsspaltung freie Radikale.

Beispiele für Typ I-Photoinitiatoren sind Triazine, wie z. B. Tris(trichlormethyl)triazin, Oxime, Benzoinether, Benzilketale, alpha-alpha-Dialkoxyacetophenon, Phenylglyoxylsäureester, Bisimidazole, Aroylphosphinoxide, z.B. 2,4,6-Trimethyl-benzoyl-diphenylphosphinoxid, Sulfonium- und Iodoniumsalze.

Typ II-Photoinitiatoren (Norrish-Typ-II) für die radikalische Polymerisation durchlaufen bei der Bestrahlung eine bimolekulare Reaktion, wobei der Photoinitiator im angeregten Zustand mit einem zweiten Molekül, dem Coinitiator, reagiert und durch Elektronen- oder Protonentransfer oder direkte Wasserstoffabstraktion die polymerisationsauslösenden Radikale bildet.

Beispiele für Typ-II-Photoinitiatoren sind Chinone, wie z. B. Campherchinon, aromatische Ketoverbindungen, wie z. B. Benzophenone in Kombination mit tertiären Aminen, Alkylbenzophenone, halogenierte Benzophenone, 4,4'-Bis(dimethylamino)benzophenon (Michlers Keton), Anthron, Methyl-p-(dimethylamino)benzoat, Thioxanthon, Ketocoumarine, alpha-Aminoalkylphenon, alpha-Hydroxyalkylphenon und kationische Farbstoffe, wie z. B. Methylenblau, in Kombination mit tertiären Aminen.

Für den UV- und kurzwelligen sichtbaren Bereich werden Typ-I- und Typ-II-Photoinitiatoren eingesetzt, für den längerwelligen sichtbaren Lichtbereich kommen überwiegend Typ-II-Photoinitiatoren zum Einsatz.

Auch die in der EP 0 223 587 A beschriebenen Photoinitiatorsysteme, bestehend aus einer Mischung aus einem Ammoniumalkylarylborat und einem oder mehreren Farbstoffen, können als Photoinitiator vom Typ II für die radikalische Polymerisation eingesetzt werden. Als Ammoniumalkylarylborat eignen sich beispielsweise Tetrabutylammonium Triphenylhexylborat, Tetrabutylammonium Triphenylbutylborat, Tetrabutylammonium Trinapthylhexylborat, Tetrabutylammonium Tris(4-tert.butyl)-phenylbutylborat, Tetrabutylammonium Tris-(3-fluorphenyl)-hexylborat, Tetramethylammonium Triphenylbenzylborat, Tetra(n-hexyl)ammonium (sec-Butyl)triphenylborat, 1-Methyl-3-octylimidazolium Dipentyldiphenylborat und Tetrabutylammonium Tris-(3-chlor-4-methylphenyl)-hexylborat (Cunningham et al., RadTech'98 North America UV/EB Conference Proceedings, Chicago, Apr. 19-22, 1998).

Die für die anionische Polymerisation verwendeten Photoinitiatoren d) sind in der Regel Typ I-Systeme und leiten sich von Übergangsmetall-Komplexen der ersten Reihe ab. Hier sind beispielsweise Chrom-Salze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152) zu nennen.

Eine weitere Möglichkeit der anionischen Polymerisation besteht in der Verwendung von Farbstoffen, wie Kristallviolett Leukonitril oder Malachitgrün Leukonitril, die durch photolytischen Zerfall Cyanoacrylate polymerisieren können (Neckers et al. Macromolecules 2000, 33, 7761). Dabei wird das Chromophor in die Polymere eingebaut, so dass die resultierenden Polymere durchgefärbt sind.

Die für die kationische Polymerisation verwendbaren Photoinitiatoren bestehen im Wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch bei Abwesenheit eines Wasserstoff-Donors ein Kation erzeugen, das die Polymerisation initiiert. Die Effizienz des Gesamtsystems wird durch die Natur des verwendeten Gegenions zur Diazonium-Verbindung bestimmt. Bevorzugt sind hier die wenig reaktiven, aber recht teuren $SbF_6^-$, $AsF_6^-$ oder $PF_6^-$. Für den Einsatz in Beschichtung dünner Filme sind diese Verbindungen in der Regel weniger geeignet, da durch den nach der Belichtung freigesetzten Stickstoff die Oberflächengüte herabgesetzt wird (pinholes) (Li et al., Polymeric Materials Science and Engineering, 2001, 84, 139).

Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalkation, welches zunächst durch H-Abstraktion in ein Kation übergeht, das schließlich ein Proton freisetzt und dadurch die kationische Polymerisation startet (Dektar et al. J. Org. Chem. 1990, 55, 639; J. Org. Chem., 1991, 56. 1838). Dieser Mechanismus ermöglicht den Einsatz von Iodonium-Salzen ebenfalls für die radikalische Photopolymerisation. Hierbei kommt der Wahl des Gegenions erneut eine große Bedeutung zu. Bevorzugt werden ebenfalls $SbF_6^-$, $AsF_6^-$ oder $PF_6^-$ verwendet. Ansonsten ist in dieser Strukturklasse die Wahl der Substitution des Aromaten recht frei und im Wesentlichen durch die Verfügbarkeit geeigneter Startbausteine für die Synthese bestimmt. Bei den Sulfonium-Salzen handelt es sich um Verbindungen, die nach Norrish-Typ II zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden in der Regel mit $SbF_6^-$ Salzen erzielt.

Da die Eigenabsorption von Iodonium- und Sulfonium-Salze bei < 300 nm liegt, sollten diese Verbindungen für die Photopolymerisation mit nahem UV oder kurzwelligem sichtbarem Licht entsprechend sensibilisiert werden. Dies gelingt durch die Verwendung von längerwellig absorbierenden Aromaten wie z.B. Anthracen und Derivaten (Gu et al., Am. Chem. Soc. Polymer Preprints, 2000, 41 (2), 1266) oder Phenothiazin bzw. dessen Derivaten (Hua et al, Macromolecules 2001, 34, 2488-2494).

Es kann vorteilhaft sein, Gemische dieser Sensibilisatoren oder auch Photoinitiatoren einzusetzen. Je nach verwendeter Strahlungsquelle muss Typ und Konzentration an Photoinitiator in dem Fachmann bekannter Weise angepasst werden. Näheres ist zum Beispiel in P. K. T. Oldring (Ed.), Chemistry & Technology of UV & EB Formulations For Coatings, Inks & Paints, Vol. 3, 1991, SITA Technology, London, S. 61 - 328 beschrieben.

Bevorzugte Photoinitiatoren d) sind Mischungen aus Tetrabutylammonium Tetrahexylborat, Tetrabutylammonium Triphenylhexylborat, Tetrabutylammonium Triphenylbutylborat, Tetrabutylammonium Tris-(3-fluorphenyl)-hexylborat ([191726-69-9], CGI 7460, Produkt der BASF SE, Basel, Schweiz) und Tetrabutylammonium Tris-(3-Chlor-4-methylphenyl)-hexylborat ([1147315-11-4], CGI 909, Produkt der BASF SE, Basel, Schweiz) mit Farbstoffen der Formel (I).

Beispiele für kationische Farbstoffe sind Astrazon Orange G, Basic Blue 3, Basic Orange 22, Basic Red 13, Basic Violett 7, Methylenblau, Neu Methylenblau, Azur A, Pyrillium I, Safranin O, Cyanin, Gallocyanin, Brilliant Grün, Kristallviolett, Ethylviolett und Thionin.

Besonders bevorzugt ist, wenn die erfindungsgemäße Photopolymer-Formulierung einen kationischen Farbstoff der Formel $F^+An^-$ enthält.

Unter kationischen Farbstoffen der Formel $F^+$ werden bevorzugt solche der folgenden Klassen verstanden: Acridin-Farbstoffe, Xanthen-Farbstoffe, Thioxanthen-Farbstoffe, Phenazin-Farbstoffe, Phenoxazin-Farbstoffe, Phenothiazin-Farbstoffe, Tri(het)arylmethan-Farbstoffe - insbesondere Diamino- und Triamino(het)arylmethan-Farbstoffe, Mono-, Di- und Trimethincyanin-Farbstoffe, Hemicyanin-Farbstoffe, extern kationische Merocyanin-Farbstoffe, extern kationische Neutrocyanin-Farbstoffe, Nullmethin-Farbstoffe - insbesondere Naphtholactam-Farbstoffe, Streptocyanin-Farbstoffe. Solche Farbstoffe sind beispielsweise in H. Berneth in Ullmann's Encyclopedia of Industrial Chemistry, Azine Dyes, Wiley-VCH Verlag, 2008, H. Berneth in Ullmann's Encyclopedia of Industrial Chemistry, Methine Dyes and Pigments, Wiley-VCH Verlag, 2008, T. Gessner, U. Mayer in Ullmann's Encyclopedia of Industrial Chemistry, Triarylmethane and Diarylmethane Dyes, Wiley-VCH Verlag, 2000 beschrieben.

Mit $An^-$ ist ein Anion gemeint. Bevorzugte Anionen $An^-$ sind insbesondere $C_8$- bis $C_{25}$-Alkansulfonat, vorzugsweise $C_{13}$- bis $C_{25}$-Alkansulfonat, $C_3$- bis $C_{18}$-Perfluoralkansulfonat, $C_4$- bis $C_{18}$-Perfluoralkansulfonat, das in der Alkylkette mindestens 3 Wasserstoffatome trägt, $C_9$- bis $C_{25}$-Alkanoat, $C_9$- bis $C_{25}$-Alkenoat, $C_8$- bis $C_{25}$-Alkylsulfat, vorzugsweise $C_{13}$- bis $C_{25}$-Alkylsulfat, $C_8$- bis $C_{25}$-Alkenylsulfat, vorzugsweise $C_{13}$- bis $C_{25}$-Alkenylsulfat, $C_3$- bis $C_{18}$-Perfluoralkylsulfat, $C_4$- bis $C_{18}$-Perfluoralkylsulfat, das in der Alkylkette mindestens 3 Wasserstoffatome trägt, Polyethersulfate basierend auf mindestens 4 Äquivalenten Ethylenoxid und/oder Äquivalenten 4 Propylenoxid, Bis-$C_4$-bis $C_{25}$-Alkyl-, $C_5$-bis $C_7$-Cycloalkyl-, $C_3$- bis $C_8$-Alkenyl- oder $C_7$- bis $C_{11}$-Aralkyl-sulfosuccinat, durch mindestens 8 Fluoratome substituiertes Bis-$C_2$- bis $C_{10}$-alkyl-sulfosuccinat, $C_8$- bis $C_{25}$-Alkyl-sulfoacetate, durch mindestens einen Rest der Gruppe Halogen, $C_4$- bis $C_{25}$-Alkyl, Perfluor-$C_1$- bis $C_8$-Alkyl und/oder $C_1$- bis $C_{12}$-Alkoxycarbonyl substituiertes Benzolsulfonat, ggf. durch Nitro, Cyano, Hydroxy, $C_1$- bis $C_{25}$-Alkyl, $C_1$- bis $C_{12}$-Alkoxy, Amino, $C_1$- bis $C_{12}$-Alkoxycarbonyl oder Chlor substituiertes Naphthalin- oder Biphenylsulfonat, ggf. durch Nitro, Cyano, Hydroxy, $C_1$- bis $C_{25}$-Alkyl, $C_1$- bis $C_{12}$-Alkoxy, $C_1$- bis $C_{12}$-Alkoxycarbonyl oder Chlor substituiertes Benzol-, Naphthalin-oder Biphenyldisulfonat, durch Dinitro, $C_6$- bis $C_{25}$-Alkyl, $C_4$- bis $C_{12}$-Alkoxycarbonyl, Benzoyl, Chlorbenzoyl oder Toluoyl substituiertes Benzoat, das Anion der Naphthalindicarbonsäure, Diphenyletherdisulfonat, sulfonierte oder sulfatierte, ggf. mindestens einfach ungesättigte $C_8$- bis $C_{25}$-Fettsäureester von aliphatischen $C_1$- bis $C_8$-Alkoholen oder Glycerin, Bis-(sulfo-$C_2$- bis $C_6$-alkyl)-$C_3$-bis $C_{12}$-alkandicarbonsäureester, Bis-(sulfo-$C_2$- bis $C_6$-alkyl)-itaconsäureester, (Sulfo-$C_2$- bis $C_6$-alkyl)-$C_6$- bis $C_{18}$-alkancarbonsäureester, (Sulfo-$C_2$- bis $C_6$-alkyl)-acryl- oder methacrylsäureester, ggf. durch bis zu 12 Halogenreste substituiertes Triscatecholphosphat, ein Anion der Gruppe Tetraphenylborat, Cyanotriphenylborat, Tetraphenoxyborat, $C_4$- bis $C_{12}$-Alkyltriphenylborat, deren Phenyl- oder Phenoxy-Reste durch Halogen, $C_1$- bis $C_4$-Alkyl und/oder $C_1$- bis $C_4$-Alkoxy substituiert sein können, $C_4$- bis $C_{12}$-Alkyl-trinaphthylborat, Tetra-$C_1$- bis $C_{20}$-alkoxyborat, 7,8- oder 7,9-Dicarba-nido-undecaborat(1-) oder (2-), die gegebenenfalls an den B- und/oder C-Atomen durch eine oder zwei $C_1$- bis $C_{12}$-Alkyl- oder Phenyl-Gruppen substituiert sind, Dodecahydro-dicarbadodecaborat(2-) oder B-$C_1$- bis $C_{12}$-Alkyl-C-phenyl-dodecahydro-dicarbadodecaborat(1-) steht, wobei bei mehrwertigen Anionen wie Naphthalindisulfonat $An^-$ für ein Äquivalent dieses Anions steht, und wobei die Alkan- und Alkylgruppen verzweigt sein können und/oder durch Halogen, Cyano, Methoxy, Ethoxy, Methoxycarbonyl oder Ethoxycarbonyl substituiert sein können.

Besonders bevorzugte Anionen sind sec-$C_{11}$- bis $C_{18}$-Alkansulfonat, $C_{13}$- bis $C_{25}$-Alkylsulfat, verzweigtes $C_8$-bis $C_{25}$-Alkylsulfat, ggf. verzweigtes Bis-$C_6$- bis $C_{25}$-alkylsulfosuccinat, sec- oder tert.-$C_4$- bis $C_{25}$-Alkylbenzolsulfonat, sulfonierte oder sulfatierte, ggf. mindestens einfach ungesättigte $C_8$- bis $C_{25}$-Fettsäureester von aliphatischen $C_1$- bis Cs-Alkoholen oder Glycerin, Bis-(sulfo-$C_2$- bis $C_6$-alkyl)-$C_3$- bis $C_{12}$-alkandicarbonsäureester, (Sulfo-$C_2$- bis $C_6$-alkyl)-$C_6$-bis $C_{18}$-alkancarbonsäureester, durch bis zu 12 Halogenreste substituiertes Triscatecholphosphat, Cyanotriphenylborat, Tetraphenoxyborat, Butyltriphenylborat.

Bevorzugt ist auch, wenn das Anion $An^-$ des Farbstoffs einen AClogP im Bereich von 1-30, besonders bevorzugt im Bereich von 1-12 und insbesondere bevorzugt im Bereich von 1-6,5 aufweist. Der AClogP wird nach J. Comput. Aid. Mol. Des. 2005, 19, 453; Virtual Computational Chemistry Laboratory, http://www.vcclab.org berechnet.

Ganz besonders bevorzugt ist, wenn der Photoinitiator eine Kombination von Farbstoffen, deren Absorptionsspektren zumindest teilweise den Spektralbereich von 400 bis 800 nm abdecken, mit wenigstens einem auf die Farbstoffe abgestimmten Coinitiator umfasst.

Bevorzugt ist auch, wenn wenigstens ein für eine Laserlichtfarbe ausgewählt aus blau, grün und rot geeigneter Photoinitiator in der Photopolymer-Formulierung enthalten ist.

Weiter bevorzugt ist auch, wenn die Photopolymer-Formulierung für wenigstens zwei Laserlichtfarben ausgewählt aus blau, grün und rot je einen geeigneten Photoinitiator enthält.

Ganz besonders bevorzugt ist schließlich, wenn die Photopolymer-Formulierung für jede der Laserfarben blau, grün und rot jeweils einen geeigneten Photoinitiator enthält.

Die Aufzeichnungsschicht kann bevorzugt eine Schichtdicke von 5 μm bis 100 μm, besonders bevorzugt von 5 μm bis 30 μm, ganz besonders bevorzugt von 10 μm bis 25 μm aufweisen.

Die Aufzeichnungsschicht kann in bevorzugten Ausführungsformen der Erfindung auf eine Trägerschicht aufgebracht sein.

Die Trägerschicht kann beispielsweise 15 bis 375 μm dick sein, bevorzugt 23 μm bis 175 μm, besonders bevorzugt 36 μm bis 125 μm.

Erfindungswesentlicher Bestandteil der Aufbauten ist die Schwarzschicht. Für die schwarze Rückseitenkaschierung eignen sich beispielsweise schwarze Klebebänder und Schwarzlacke. Vorzugsweise werden solche schwarzen Schichten eingesetzt, bei welchen der Absorptionsquotient $Q \leq 0{,}70$, bevorzugt $Q \leq 0{,}55$ und besonders bevorzugt $Q \leq 0{,}52$ liegt. Der Absorptionsquotient Q beschreibt das Verhältnis der Reflektion einer Glasplatte mit Schwarzschicht im Vergleich zu derselben Glasplatte ohne Schwarzschicht bei 532 nm.

Beispiele geeigneter Schwarzschichten sind Klebebänder mit schwarzer Trägerfolie und/ oder schwarzer Klebstoffschicht, schwarze Folien sowie Schwarzlacke. Als schwarze Trägerfolie für Klebstoffbänder sind im Prinzip dieselben Materialien geeignet wie vorstehend zur Trägerschicht beschrieben, sofern diese durch Pigmentierung geschwärzt wurden. Bevorzugt ist es, wenn die Trägerfolie eine Schichtdicke von 23 μm bis 175 μm besitzt, besonders bevorzugt 36 μm bis 80 μm. Als Material sind Polycarbonat, Polyethylen, Polypropylen, PET sowie Folien Copolymere aus 1-Olefinen besonders bevorzugt.

Als Klebstoffe sind prinzipiell alle Klebstoffe geeignet, die typischerweise in selbstklebenden Klebebändern (pressure-sensitive adhesives, PSAs, Haftklebebändern) Anwendung finden. Haftklebstoffe (PSA = pressure sensitive adhesive) sind permanent klebrige Produkte, die im Kontakt mit Substraten bereits unter Anwendung eines leichten Anpressdruckes Adhäsion aufbauen. Der Verklebungsprozess erfolgt zeitlich unabhängig von der Applikation des Klebstoffes in der Regel auf einem Trägermaterial wie einem Release Liner, einem Abzugspapier oder einem (Folien-)Träger. Es kann verfahrensbedingt dennoch günstig sein, Haftklebstoffe bei erhöhten Temperaturen zu verarbeiten. Weitere Informationen in Müller/Rath, Formulierung von Kleb- und Dichtrohstoffen, 2009, ISBN: 978-3-86630-862-6, Teil II, Kapitel 3.

Bevorzugt sind dies Silikon-basierte, Acrylat-basierte (auch solche auf Basis modifizierter Acrylate) und kautschuk-basierte Klebstoffe. Besonders bevorzugt sind Acrylat- und Kautschuk-basierte Klebstoffe.

Unter siliconbasierten Klebstoffen werden solche verstanden, deren Verknüpfungseinheiten Silikongruppen enthalten oder ausschließlich aus solchen bestehen. Silicone sind siliciumorganische Verbindungen, die im Rückgrat nur Si-O-Bindungen aufweisen. Häufig werden Silicone in Form von (Block- oder Graft-)Copolymeren mit Polyethern oder Polyestern oder anderen Polymereinheiten eingesetzt (modifizierte Silikone). Die Modifikationen erfolgen über die organischen Seitengruppen an den Siliciumatomen. Weitere Informationen in Müller/Rath, Formulierung von Kleb- und Dichtrohstoffen, 2009, ISBN: 978-3-86630-862-6, Teil III, Kapitel 3.2.3.

Unter Synthesekautschuken versteht man neben den Poly(isoprenen) auch Copolymerisate, die als weitere Monomere Acrylnitril und Derivate, Butadien, Styrol, Isobuten und andere umfassen oder daraus bestehen. Typische Copolymerisate sind Butadien-Nitril-Kautschuke (NBR), Styrol-Butadien-Kautschuke (SBR) und Isopren-Isobutylen-Kautschuke (IIR). Weitere Informationen in Müller/Rath, Formulierung von Kleb- und Dichtrohstoffen, 2009, ISBN: 978-3-86630-862-6, Teil II, Kapitel 1.1.2.3 und 1.2.2.

Unter Acrylat-basierten Haftklebstoffen versteht man die oft löslichen, radikalischen Polymerisate von Estern der Acryl- und Methacrylsäure mit breiter Molmassenverteilung und tiefer Glasübergangstemperatur. Bevorzugt werden dabei die Ester mit Alkoholen mit 4 bis 12 C-Atomen eingesetzt, besonders häufig Butylacrylat und 2-Ethylhexylacrylat. Teilweise können Comonomere wie Styrol, Vinylacetat usw. Anwendung finden. Es kann bevorzugt sein, die erhaltenen Acrylatpolymere noch thermisch oder durch UV-Strahlung nachzuvernetzen.

Weiterhin ist es möglich statt eines Klebebandes einen schwarz eingefärbten Schmelzklebstoff oder eine Schmelzklebstofffolie zu verwenden. Unter Schmelzklebstoffen versteht man amorphe oder teilkristalline Polymere, deren Glastemperatur oder kristalliner Punkt über der Raumtemperatur liegt. Bei Erwärmen über diesen Temperaturbereich hinaus erfolgt eine (teilweise langsame) Verflüssigung und es wird ein Viskositätsverhalten erreicht, das für eine Verklebung geeignet ist. Bei Abkühlen erfolgt dann Rekristallisation bzw. Verfestigung. Im Prinzip können auf diesem Weg auch hochmolekulare Polymere, deren Glastemperatur unterhalb der Raumtemperatur liegt als Schmelzklebstoffe fungieren. Solche Polymere sind beispielsweise durch Trocknung von Dispersionen oder physikalischen Lösungen

zugänglich. Weitere Informationen in Müller/Rath, Formulierung von Kleb- und Dichtrohstoffen, 2009, ISBN: 978-3-86630-862-6, Kapitel 1.1.2.3 und 1.3.1.

Bevorzugte Schmelzklebstoffe bestehen aus Polyolefin-basierten Klebstoffen, thermoplastischem Polyurethan oder sind polyester-basiert. Unter polyesterbasierten Schmelzklebstoffen werden solche verstanden, die zu einem wesentlichen Gewichtsanteil von > 30 %, bevorzugt > 50% aus Polyestereinheiten bestehen. Bevorzugt werden thermoplastische Polyurethane und polyester-basierte Schmelzklebstoffe verwendet. Besonders bevorzugt werden solche verwendet, deren Schmelzbereich unter 150°C, insbesondere bevorzugt unter 120 °C liegt.

Bevorzugt erfolgt die schwarze Einfärbung des Klebstoffes durch Ruß oder Carbon Black (Kohlenstoffschwarz). Es ist aber auch jede andere dem Fachmann bekannte Pigmentierung geeignet.

Als Schwarzlacke sind prinzipiell alle Lacke geeignet, die durch geeignete Pigmentierung angefärbt werden können. Neben den oben genannten Pigmenten kommen dafür auch Holz- oder Knochenkohle oder Schwarzpigmente wie Eisen- oder Manganschwarz in Betracht. Besonders geeignet sind Schwarzpigmente auf Basis von Eisenverbindungen oder Carbon Black.

Die Lacke können generell durch alle dem Fachmann bekannten Techniken aufgetragen werden. Bevorzugt sind Rakel, Siebdruck und Spritzen, besonders bevorzugt sind Rakel oder Spritzen.

Bei Ausgestaltungen des erfindungsgemäßen Schichtaufbaus, bei denen die Schwarzschicht nicht unmittelbar auf der Substratschicht aufgebracht ist, , können als Schwarzschicht auch schwarze Folien verwendet werden, die nach der Aufbringung des Photopolymers bzw. der Photopolymerformulierung auf die Trägerschicht unmittelbar auf die andere freie Seite der Aufzeichnungsschicht appliziert werden können.

Im Prinzip sind dafür dieselben Materialien geeignet wie vorstehend zur Trägerschicht beschrieben, sofern diese durch Pigmentierung geschwärzt wurden. Besonders geeignet sind schwarze Polyethylen-, Polypropylen-, PET-Folien sowie Folien aus olefinischen (besonders bevorzugt 1-Olefinen) Copolymeren.

Es ist besonders vorteilhaft, wenn die Schwarzschicht entweder direkt auf dem Substrat appliziert wird oder in einer derartigen Weise auf die Aufzeichnungsschicht oder die Trägerschicht aufgebracht wird, dass sie leicht wieder entfernt werden kann. Beispiele dafür sind abziehbare Kaschierfolien, abziehbare Schwarzlacke oder leicht und rückstandslos zu entfernende Klebebänder.

Weiterhin sind solche besonders geeignet, deren Klebstoff- oder Lackschicht sich ohne Lufteinschlüsse an die transparente Substratplatte anhaftet und keine Partikelstörungen aufweist oder keine Streupartikel enthält.

Als Substratschicht können im Prinzip alle planen und transparenten Materialien verwendet werden. Bevorzugt sind transparente Kunststoff- und Glassubstrate mit einer hemisphärischen Transmission gemäß ASTM E 1348 nach D65/10° von > 80% bevorzugt > 89%, sowie einem Haze von < 0,5% bevorzugt < 0,1%. Insbesondere bevorzugt sind Glassubstrate. Die Glassubstrate sind besonders bevorzugt planare Flachgläser von 2 mm bis 25 mm Dicke.

Der erfindungsgemäße Schichtaufbau sollte partikel- und störstellenfrei hergestellt werden. Es ist daher von besonderem Vorteil, wenn alle Arbeitsschritte unter staubfreier, gereinigter Luft oder im Reinraum durchgeführt werden.

Ebenfalls ist es bevorzugt, wenn die Materialien für die Substratschicht gereinigt werden, z.B. durch Verwenden einer Spülmaschine, Spülmittel, Wasser oder Lösungsmitteln. Es ist besonders bevorzugt, wenn die Materialien der Substratschicht im letzten Reinigungsschritt mit vollentsalztem oder destilliertem Wasser gespült und staubfrei mit Druckluft oder fusselfreien Tüchern getrocknet werden.

Weiterhin ist es bevorzugt wenn zur Herstellung des erfindungsgemäße Schichtaufbaus ein Schichtverbund aus Aufzeichnungsschicht und Trägerfolie verwendet wird, wie er wie weiter oben beschrieben durch Auftragung der Photopolymerformulierung auf eine Trägerfolie zugänglich ist. Beispielsweise kann direkt einen Schichtverbund aus den Schichten Aufzeichnungsschicht, Trägerfolie und Substratschicht in dieser Schichtabfolge erzeugt werden. Wird eine andere Schichtabfolge gewählt, kann es besonders bevorzugt sein, die Schwarzschicht direkt nach der Auftragung der Aufzeichnungsschicht auf die Trägerfolie aufzubringen.

Die Erzeugung des Schichtverbundes aus Aufzeichnungsschicht und Trägerfolie sowie gewünschtenfalls zusätzlich der Schwarzschicht auf die Substratschicht erfolgt bevorzugt durch Lamination. Dazu sind im Prinzip alle Formen von Laminatoren ausgehend von einer Handrolle bis hin zu Laminationsmaschinen geeignet wie Sie dem Fachmann bekannt sind. Bevorzugt werden Rollen- und/oder Flachbettlaminatoren eingesetzt. Besonders bevorzugt werden Flachbettlaminatoren eingesetzt, insbesondere bevorzugt solche mit Druckwalze unter einem Arbeitsdruck zwischen 1 und 6 bar.

Wird beispielsweise als Schwarzschicht eine schwarze Klebstoffschicht oder ein Schwarzlack verwendet, so ist es bevorzugt den Verbund aus Schwarzschicht und Substratschicht herzustellen bevor man den Schichtverbund aus Aufzeichnungsschicht und Trägerfolie aufbringt.

Zur Auftragung einer Klebstoffschicht eignen sich ebenfalls oben beschriebene Laminationsmethoden. Auch hier ist die Verwendung von Rollen- und/oder Flachbettlaminatoren bevorzugt. Besonders bevorzugt werden Flachbettlaminatoren eingesetzt. Es kann je nach Art der Klebstoffschicht vorteilhaft sein, heißlaminationsfähige Geräte wie z.B. solche mit beheizbarer Druckwalze zu verwenden und die Lamination bei erhöhter Temperatur durchzuführen.

Zur Applikation eines Schwarzlackes als Schwarzschicht sind alle jeweiligen gängigen, dem Fachmann bekannten Beschichtungs- oder Druckverfahren geeignet, wie insbesondere Rakeln, Gießen, Schlitzdüse, Drucken, Siebdruck, Spritzen, oder Inkjet-Druck. Bevorzugt sind Kastenrakel, Spiralrakel, Siebdruck und Spritzen. Ganz besonders bevorzugt wird ein Schwarzlack als Schwarzschicht durch Spritzen aufgetragen. Weiterhin ist es dabei bevorzugt die Formulierung vorher durch geeignete Filter zu filtrieren und somit Partikel abzutrennen. Der Einsatz in Spritzkammern mit gereinigter Luft / Atmosphäre ist ebenfalls bevorzugt.

Die vorliegende Erfindung wird im Folgenden anhand von Beispielen und den Figuren 1 bis 8 näher erläutert. Darin zeigt

Fig. 1 eine erste Ausführungsform eines erfindungsgemäßen Schichtaufbaus,

Fig. 2 eine zweite Ausführungsform eines erfindungsgemäßen Schichtaufbaus,

Fig. 3 eine dritte Ausführungsform eines erfindungsgemäßen Schichtaufbaus,

Fig. 4 den schematischen Aufbau einer Folienbeschichtungsanlage zur Herstellung von Photopolymerfilmen

Fig.5 die Geometrie eines Holographic Media Testers (HMT) bei $\lambda$ = 633 nm (Helium Neon Laser): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha 0$ = -16.8°, $\beta 0$ = 36.8° sind die Einfallswinkel der kohärenten Strahlen außerhalb der Probe (des Mediums) gemessen. RD = Referenzrichtung des Drehtisches,

Fig. 6 die gemessene Beugungseffizienz $\eta$ als Kreise gegen den Drehwinkel $\Omega$ aufgetragen und die Anpassung der Kogelnik Theorie als durchgezogene Linie, sowie die transmittierte Leistung auf der rechten y-Achse ohne Schwarzschicht,

Fig. 7 die Messkurve der Fig. 6 bei Verwendung einer Schwarzschicht, sowie

Fig. 8 den Probenaufbau und die verwendete Probenorientierung.

In den Fign. 1 bis 3 sind jeweils unterschiedliche Ausführungsformen eines erfindungsgemäßen Schichtaufbaus 100, 200, 300 mit jeweils einer Aufzeichnungsschicht 101, einer transparenten Trägerschicht 102 in Form einer Folie, einer Schwarzschicht 103 in Form einer schwarzen Klebstoffschicht mit einem Folienträger und einer Substratschicht 104.

**Einsatzstoffe für die Photopolymerschichten:**

<u>Komponente A:</u>

Produkt der Bayer MaterialScience AG, Leverkusen, Deutschland, die Herstellung ist unten beschrieben.

<u>Komponente B1</u> (Phosphorthioyltris(oxy-4,1-phenyleniminocarbonyloxyethan-2,1-diyl)-triacrylat):

Produkt der Bayer MaterialScience AG, Leverkusen, Deutschland, die Herstellung ist unten beschrieben.

<u>Komponente B2</u> (2-({[3-(Methylsulfanyl)phenyl]carbamoyl}oxy)ethylprop-2-enoat):

Produkt der Bayer MaterialScience AG, Leverkusen, Deutschland, die Herstellung ist unten beschrieben.

<u>Komponente C</u> (Bis(2,2,3,3,4,4,5,5,6,6,7,7-dodecafluorheptyl)- (2,2,4-trimethylhexan- 1,6-diyl) biscarbamat):

Produkt der Bayer MaterialScience AG, Leverkusen, Deutschland, die Herstellung ist unten beschrieben.

<u>Komponente D:</u>

Fascat 4102 0,07 %, Urethanisierungskatalysator, Butylzinn-tris(2-ethylhexanoat), Produkt der Arkema GmbH, Düsseldorf, Deutschland.

BYK® 310:

silikonbasiertes Oberflächenadditiv der Firma BYK-Chemie GmbH, Wesel, Deutschland, 25%ige Lösung in Xylol

Komponente E:

C. I. Basic Blue 3 als Bis-(2-ethylhexyl)sulfosuccinat 0,26 %, Safranin O als Bis-(2-ethylhexyl)sulfosuccinat 0,13 % und Astrazon Orange G als Bis-(2-ethylhexyl)sulfosuccinat 0,13% mit CGI 909 (Versuchsprodukt der Fa.BASF SE, Basel, Schweiz) 1,5%, als Lösung in 5,8% Ethylacetat gelöst. Prozentgehalte beziehen sich auf die Gesamtformulierung des Mediums. Die Herstellung der Farbstoffe ist bekannt aus PCT/EP 2011/069389.

Komponente F:

Ethylacetat (CAS-Nr. 141-78-6).

Komponente G:

Desmodur® N 3900, Handelsprodukt der Bayer MaterialScience AG, Leverkusen, Deutschland, Hexandiisocyanat-basiertes Polyisocyanat, Anteil an Iminooxadiazindion mindestens 30 %, NCO-Gehalt: 23,5 %.

Trägersubstrate:

Trägerfolie 1 ist Hostaphan® RNK 36 μm, ein Produkt der Mitsubishi Polyester Film GmbH, Wiesbaden, Deutschland.

Trägerfolie 2 ist Transphan® OG 622 SL (60 μm), ein Produkt der LOFO High Tech Film GmbH, Weil am Rhein, Deutschland.

Trägerfolie 3 ist Tacphan® 915 GL (50 μm), ein Produkt der LOFO High Tech Film GmbH, Weil am Rhein, Deutschland.

**Herstellungsvorschriften weiterer Einsatzstoffe für die Photopolymerformulierungen:**

Herstellung von Komponente A:

In einem 1 L Kolben wurden 0,18 g Zinnoktoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsartiger Feststoff erhalten.

Herstellung von Komponente B1 (Phosphorthioyltris(oxy-4,1-phenyleniminocarbonyloxyethan-2,1-diyl)-triacrylat):

In einem 500 mL Rundkolben wurden 0,1 g 2,6-Di-tert.-butyl-4-methylphenol, 0,05 g Dibutylzinndilaurat (Desmorapid® Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0,1 % gesunken war. Danach wurde abgekühlt und im Vakuum das Ethylacetat vollständig entfernt. Das Produkt wurde als teilkristalliner Feststoff erhalten.

Herstellung von Komponente B2 (2-({[3-(Methylsulfanyl)phenyl]carbamoyl}oxy)ethylprop-2-enoat):

In einem 100 mL Rundkolben wurden 0,02 g 2,6-Di-tert.-butyl-4-methylphenol, 0,01 g Desmorapid® Z, 11.7 g 3-(Methylthio)phenylisocyanat vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0,1 % gesunken war. Danach wurde abgekühlt. Das Produkt wurde als hellgelbe Flüssigkeit erhalten.

Herstellung des Additives C (Bis(2,2,3,3,4,4,5,5,6,6,7,7-dodecafluorheptyl)-(2,2,4-trimethylhexan-1,6-diyl)biscarbamat):

In einem 2000 mL Rundkolben wurden 0,02 g Desmorapid® Z und 3,60 g 2,4,4-Trimethylhexane-1,6-diisocyanat

(TMDI) vorgelegt und auf 70 °C erwärmt. Anschließend wurden 11,39 g 2,2,3,3,4,4,5,5,6,6,7,7-Dodecafluorheptan-1-ol zugetropft und die Mischung weiter auf 70 °C gehalten, bis der Isocyanatgehalt unter 0,1 % gesunken war. Danach wurde abgekühlt. Das Produkt wurde als farbloses Öl erhalten.

**Herstellung von holografischen Medien**

Im Folgenden wird die kontinuierliche Herstellung von holografischen Medien in der Form von Filmen aus erfindungsgemäßen und nicht erfindungsgemäßen Photopolymer-Formulierungen beschrieben.
Zur Herstellung wurde die in Fig. 4 beschriebene Folienbeschichtungsanlage verwendet.
Fig. 4 zeigt den schematischen Aufbau der verwendeten Beschichtungsanlage. In Fig. 4 haben die einzelnen Bauteile die folgenden Bezugszeichen:

1 Vorratsbehälter

2 Dosiereinrichtung

3 Vakuumentgasungseinrichtung

4 Filter

5 Statischer Mischer

6 Beschichtungseinrichtung

7 Umlufttrockner

8 Trägerfolie

9 Abdeckschicht

Zur Herstellung der Photopolymer-Formulierung wurden in einem Rührbehälter 304,3g Komponente A (Polyol) schrittweise mit einer Schreibmonomermischung aus 138g Komponente B1 und 138g Komponente B2, mit 191g Additiv C, 0,60g Komponente D, 2,55g BYK® 310 und 101g Komponente F versetzt und gemischt. Anschließend wurden 66,5g Komponente E der Mischung im Dunklen hinzugefügt und vermischt, so dass eine klare Lösung erhalten wurde. Wenn nötig, wurde die Formulierung für kurze Zeit bei 60 °C erwärmt, um die Einsatzstoffe schneller in Lösung zu bringen. Dieses Gemisch wurde in einen der beiden Vorratsbehälter 1 der Beschichtungsanlage eingebracht. In den zweiten Vorratsbehälter 1 wurde die Komponente G (Polyisocyanat) eingefüllt. Beide Komponenten wurden dann jeweils durch die Dosiereinrichtungen 2 im Verhältnis von 942,2 (Komponenten A bis F) zu 57,8 (Komponente G) zur Vakuumentgasungseinrichtung 3 gefördert und entgast. Von hier aus wurden sie dann jeweils durch die Filter 4 in den statischen Mischer 5 geleitet, in dem die Vermischung der Komponenten zur Photopolymer-Formulierung erfolgte. Die erhaltene, flüssige Masse wurde dann im Dunklen der Beschichtungseinrichtung 6 zugeführt.
Bei der Beschichtungseinrichtung 6 handelte es sich im vorliegenden Fall um ein dem Fachmann bekannte Schlitzdüse. Alternativ kann aber auch ein Rakelsystem (Doctor Blade). zum Einsatz kommen. Mit Hilfe der Beschichtungseinrichtung 6 wurde die Photopolymer-Formulierung bei einer Verarbeitungstemperatur von 20 °C auf die Trägerfolie 1, 2 oder 3 appliziert und für 5,8 Minuten bei einer Vernetzungstemperatur von 80°C in einem Umlufttrockner 7 getrocknet. Dabei wurde ein Medium in der Form eines Films erhalten, der dann mit einer 40 μm dicken Polyethylenfolie als Abdeckschicht 9 versehen und aufgewickelt wurde.
Die erzielte Schichtdicke des Films lag bei 18 μm.

**Einsatzstoffe für die Schwarzschicht**

Schwarzschicht 1 ist SK 5545 AD 68 S2, ein Produkt der Firma Bischof + Klein GmbH & Co. KG, Lengerich, Deutschland, Klebefolie aus Acrylatklebstoff auf schwarzer Polypropylen-Folie. Absorptionsquotient Q = 0,519.
Schwarzschicht 2 ist Dupli-Color platinum, ein Produkt der MOTIP DUPLI GmbH, Haßmersheim, Deutschland, acrylbasierter Sprühlack, appliziert in 80 μm Schichtdicke. Absorptionsquotient Q = 0,503. Schichtdicke der Lackschicht 45 μm.
Schwarzschicht 3 ist Dupli-Color Quality Paint Tiefschwarz Matt, ein Produkt der MOTIP DUPLI GmbH, Haßmersheim, Deutschland, wetterfester Kunstharz-Sprühlack, appliziert in 80 μm Schichtdicke. Absorptionsquotient

Q = 0,510. Schichtdicke der Lackschicht 35 μm.

Schwarzschicht 4 ist Marabu Buntlack Colorspray Professional, seidenmatt, ein Produkt der Marabu GmbH & Co. KG, Tamm, Deutschland, Kunstharz-Sprühlack, appliziert in 80 μm Schichtdicke. Absorptionsquotient Q = 0,497. Schichtdicke der Lackschicht 50 μm.

Schwarzschicht 5 ist ein Produkt der Bayer MaterialScience AG, Leverkusen, Deutschland, die Herstellung ist unten beschrieben. Absorptionsquotient Q = 0,501. Schichtdicke der Lackschicht 30 μm.

Schwarzschicht 6 ist ein Produkt der Bayer MaterialScience AG, Leverkusen, Deutschland, die Herstellung ist unten beschrieben. Absorptionsquotient Q = 0,507. Schichtdicke der Lackschicht 40 μm.

Schwarzschicht 7 ist ein Klebeband mit dem Produktcode Scotch, Vinyl Electrical Tape 22 der 3M Deutschland GmbH, Neuss, Deutschland. Absorptionsquotient Q = 0,507.

Schwarzschicht 8 ist ein Klebeband mit dem Produktcode n-10-129 der nolax AG, Sempach-Station, Schweiz (Typ: kautschuk-basiertes Haftklebeband mit schwarzer Polycarbonat-Trägerfolie). Absorptionsquotient Q = 0,549.

Schwarzschicht 9 ist ein Klebeband mit dem Produktcode Scotchcal 70 der 3M Deutschland GmbH, Neuss, Deutschland (Typ: Haftklebeband auf Acrylatbasis mit schwarzer Trägerfolie). Absorptionsquotient Q = 0,508.

Schwarzschicht 10 ist ein Klebeband mit dem Produktcode AF 24.449 der AF Adhäsive Formteile GmbH, Pfinztal, Deutschland (Typ: silicon-basiertes Haftklebeband mit schwarzer Trägerfolie). Absorptionsquotient Q = 0,650.

Schwarzschicht 11 ist ein Klebeband mit dem Produktcode AF 01.9473 der AF Adhäsive Formteile GmbH, Pfinztal, Deutschland (Typ: acrylat-basiertes Haftklebeband mit schwarzer Trägerfolie). Absorptionsquotient Q = 0,510.

Schwarzschicht 12 verwendet das Produkt Araldite 2026 A der Huntsman Advanced Materials (Europe) BVBA, Everberg, Belgien (zweikomponentiger Flüssigklebstoff auf Basis von Polyurethanen) und das Produkt Makrofol DE 1-4, schwarz, der Bayer MaterialScience AG, Leverkusen, Deutschland, die Herstellung ist unten beschrieben. Absorptionsquotient Q = 0,514. Schichtdicke der ausgehärteten Klebstoffschicht 40 μm.

Herstellung der Schwarzschicht 5:

In einem Anreibebehälter mit Kühlvorrichtung werden bei Raumtemperatur 29,06 g Desmophen A160 (Produkt der Nuplex Resins GmbH, Bitterfeld-Wolfen, Deutschland, als 60%-ige Lösung in Solvent Naphtha) vorlegt und mit 0,20 g BYK® 141 (Produkt der BYK-Chemie GmbH, Wesel, Deutschland) und 12,0 g Solvesso 100 (Produkt der Azelis Deutschland GmbH, Sankt Augustin, Deutschland) versetzt. Anschließend werden 1,0 g Kieselsäure CAB-O-SIL® TS-720 (Produkt der Cabot Rheinfelden GmbH & Co. KG, Rheinfelden, Deutschland) per Hand untergerührt und dann 26,32 g Bayferrox 318 M (Produkt der LANXESS Deutschland GmbH, Leverkusen, Deutschland, CAS-Nr. 1317-61-9) und 18 g Micro-Talc (Produkt der Mondo Minerals BV, Amsterdam, Niederlande, CAS-Nr. 14807-96-6) portionsweise zugegeben. Im Folgenden wird die Lackmischung mit ca. 17,3 g Glasperlen 2,6-3 mm (Produkt der Sigmund Lindner GmbH, Warmensteinach, Deutschland) versetzt und im Dissolver bei 2400 U/min über 30 min. mit einer Kunststoffscheibe angerieben. Es wird mit Wasser gekühlt so dass die Temperatur bei max. +40 °C liegt, dann abgesiebt und 1d bei RT inkubiert.

Herstellung der Schwarzschicht 6:

In einem Anreibebehälter werden bei Raumtemperatur 305,50g Bayhydrol UH 2593/1 (Produkt der Bayer MaterialScience AG, Leverkusen, Deutschland, aliphatische, fettsäuremodifizierte, anionische Polyurethandispersion) und 105,50g Bayhydrol UH 240 (Produkt der Bayer MaterialScience AG, Leverkusen, Deutschland, aliphatische, anionische Polyester-Polyurethan-Dispersion) vorgelegt. Unter Rühren mit einer Dissolverscheibe bei 800 - 1000 Upm (Schaumbildung ist zu vermeiden) werden die Bindemittel 1min homogen vermischt und anschließend nacheinander 1,00g BYK® 022 (Produkt der BYK-Chemie GmbH, Wesel, Deutschland), 1,00 g BYK® 028 (Produkt der BYK-Chemie GmbH, Wesel, Deutschland), 3,00g BYK® 346 (Produkt der BYK-Chemie GmbH, Wesel, Deutschland) und 3,75 g Soja-Lecithin W 250 (Produkt der Lubrizol Deutschland GmbH, Ritterhude, Deutschland) zugegeben und jeweils 5min nachgerührt. Anschließend wird 1,50g Borchi Gel 0625 (Produkt der OMG Borchers GmbH, Langenfeld, Deutschland) zugegeben und 10min nachgerührt. Zuletzt werden 75,00 g Butylglykol (Produkt der Brenntag GmbH, Mülheim/Ruhr, Deutschland), 50% in VE-Wasser gelöst, und 53,65g wässrige Pigmentpaste schwarz (bestehend aus 10,4 Gew.-% Setaqua B E 270, Produkt der Nuplex Resins GmbH, Bitterfeld-Wolfen, Deutschland und 41,6 Gew.-% VE-Wasser, vermischt mit 32,0 Gew.-% Borchi Gel 0851, Produkt der OMG Borchers GmbH, Langenfeld, Deutschland und 16,0 Gew.-% Colour Black FW 200, Produkt der Degussa AG, Frankfurt a. Main, Deutschland) zugegeben. Beides wird kurz hintereinander zugegeben und der gesamte Ansatz nochmals 10min nachgerührt.

Herstellen eines beispielhaften Aufbau 1:

1. Voreinigen der Glasplatten:

Wenn es das Format zulässt werden die Glasplatten in der Laborspülmaschine im Standardprogramm + Trockenprogramm vorgereinigt. Ansonsten wird das Glas manuell mit Schwamm Spülmittel und Wasser gereinigt, mit VE-Wasser klar gespült und mit Druckluft abgeblasen sowie mit einem sauberen Papiertuch nachgetrocknet. Große Glasplatten werden dabei zur besseren Handhabung auf einem Gestell abgelegt und gereinigt.

2. Aufbringen des Black-Backing

a) Aufbringen der Schwarzschicht 1

Bei Glasplatten bis 200mm x 100mm wird im GSH 380 Rollenlaminator von Rolle zu Glas das Klebeband aufgebracht, indem es zwischen den Rollen eingezogen und dann die einzelnen Glasplatten eingeschoben werden. Anschließend werden die beklebten Glasplatten mit einem Cuttermesser ausgeschnitten. Um mit dem Klebeband eine vollflächige Kontaktierung zu erreichen wird unter Zuhilfenahme eines Kunststoffspachtels oder Rakels die Folie manuell an das Glas der einzelnen Muster angedrückt und eingeschlossene Luft ggf. herausgestrichen.

b) Aufbringen der Schwarzschichten 2 bis 4

Der Schwarzsprühlack wird nachdem die Glasoberfläche der zu lackierenden Glasplatte mit Aceton entfettet wurde, direkt aus der vorher geschüttelten Spraydose mit 6 Kreuzgängen lackiert und 1d bei RT getrocknet. Die nicht zu lackierende Rückseite wird währenddessen mit Kreppklebeband abgeklebt.

c) Aufbringen der Schwarzschichten 5 und 6

Die oben beschriebene Lackformulierung wird in einem Polymerbecher mit 9,07 g Desmodur® N 75 MPA / Xylol (Produkt der Bayer MaterialScience AG, Leverkusen, Deutschland) versetzt, anschließend mit einem Holzspatel ca. 1 min. homogen verrührt und durch einen 240μm Schnellfilter in die Spritzpistole geben.
Der Schwarzsprühlack wird nachdem die Glasoberfläche der zu lackierenden Glasplatte mit Aceton entfettet wurde mit einer Hand-Spritzpistole mit 1,5 Kreuzgängen bei 5bar und 1,4mm Düse lackiert und 1d bei RT getrocknet. Die nicht zu lackierende Rückseite wird währenddessen mit Kreppklebeband abgeklebt.

3. Auflaminieren von Photopolymer auf (rückseitig geschwärzte) Glasplatten

Eine Glasplatte, die auf der anderen Seite bereits mit einer Schwarzschicht versehen wurde, wird mit der zu laminierenden Oberfläche nach oben zurechtgelegt. Die Oberfläche wird vor der Lamination mit filtriertem EtOH, PA-Ware besprüht und mit einem fusselfreien Synthetik-Tuch kreisend abgewischt. Anschließend wird sofort das vorkonfektionierte Photopolymerstück, das in seiner Größe etwa 1 bis 2 cm den Rand der Glasplatte überragt, dekaschiert und unter Verwendung einer Laminationshandrolle mit leichtem Druck und einer fließenden Bewegung auf die Glasplatte auflaminiert. Um die überstehenden Ränder zu entfernen wird mit einem Cuttermesser und zentriertes Auflegen einer passenden Schablone, die am Rand jeweils ca. 6mm kleiner ist als die Glasplatte, über das Glas gefahren und der Verschnitt entfernt. Die fertigen Muster werden lichtdicht in Alubeutel verpackt und verschweißt.

Messmethoden:

**Messung der Reflektion an der Schwarzschicht**

Das Transmissions- und Reflexionsspektrum des Schichtpaketes aus Glasträger und Schwarzschicht wurde mit einem Spektrometer der Firma STEAG ETA-Optik, CD-Measurement System ETA-RT gemessen. Die Schwarzschicht war dabei auf der zur Lichtquelle abgewandten Seite des Glasträgers aufgebracht. Als Referenz wurde auch der blanke Glasträger vermessen. Die Reflektion der Probe und der Referenz wurde jeweils den Spektren bei 532 nm entnommen. Zur Auswertung wurde der Quotient aus der Reflektion der Probe und der Reflektion der Referenz gebildet. Dieser Wert wird als Absorptionsquotient Q bezeichnet.

## Messung der Schichtdicke der Schwarzschichten

Die Dicke der Schwarzschichten wurden mit einer Mikrometerschraube der Firma Mitutoyo Corporation, Kanagawa, Japan gemessen. Dafür wurden zunächst an mehreren Punkten die nicht beschichtete Unterlage in der Dicke vermessen, dann nach der Beschichtung die Unterlage zusammen mit der Schwarzschicht. Aus beiden Werten wurde über die Differenz die Dicke der Schwarzschicht bestimmt.

## Messung der Trockenschichtdicke der Photopolymere

Die physikalische Schichtdicke wurde mit marktgängigen Weisslichtinterferometern ermittelt, wie z.B. das Gerät FTM-Lite NIR Schichtdickenmessgerät der Firma Ingenieursbüro Fuchs.

Die Bestimmung der Schichtdicke beruhte im Prinzip auf Interferenzerscheinungen an dünnen Schichten. Dabei überlagerten sich Lichtwellen, die an zwei Grenzflächen unterschiedlicher optischer Dichte reflektiert worden sind. Die ungestörte Überlagerung der reflektierten Teilstrahlen führte nun zur periodischen Aufhellung und Auslöschung im Spektrum eines weißen Kontinuumstrahlers (z.B. Halogenlampe). Diese Überlagerung nennt der Fachmann Interferenz. Die Interferenzspektren wurden gemessen und mathematisch ausgewertet.

## Festgehalt

Ca. 1g der Probe wurde in einem unlackierten Dosendeckel aufgetragen und mittels einer Büroklammer gut verteilt. Dosendeckel und Büroklammer wurden zuvor gewogen. Die Probe mit Büroklammer und Dosendeckel wurden eine Stunde bei 125°C in einem Ofen getrocknet. Der Festgehalt ergab sich: (Auswaage-Tara)*100 / (Einwaage-Tara).

## Viskosität

Die angegebenen Viskositäten wurden mit einem Auslaufbecher DIN 4 mm durchgeführt; entsprechend DIN EN ISO 2431 bzw. DIN 53211 (DIN4 Becher).

## Isocyanatgehalt (NCO-Gehalt)

Die angegebenen NCO-Werte (Isocyanat-Gehalte) wurden gemäß DIN EN ISO 11909 bestimmt.

## Messung der totalen Transmission und des Haze-Wertes

Die Messungen werden auf einem Kugelspektrometer vom Typ Hunter Ultrascan Pro von Hunter Lab, FMS Jansen GmbH & Co. KG, Murnau am Staffelsee, Deutschland in Anlehnung an die Norm ASTM E 1348 / ISO 13468 für die Bestimmung der totalen Transmission durchgeführt. Als totale Transmission wird dabei der Mittelwert der Transmission zwischen 360 nm und 840 nm bezeichnet, wobei jeweils 1 Einzelmessung pro 5 nm durchgeführt wird. Zur Messung wird die Lampenart D65 und ein Beobachtungswinkel von 10° benutzt. Der Messbereich ist von 350nm- 1100nm, wobei für die farbmetrische Bestimmung nur bis 850nm gemessen wird. Als Eichung wird eine Messung an Luft verwendet und die Transmission dieser Messung auf 100% gesetzt.

Der Haze-Wert wird gemäß der Norm ASTM D 1003 ermittelt.

## Messung der holografischen Eigenschaften DE und Δn der holografischen Medien mittels Zweistrahlinterferenz in Transmissionsanordnung und Beurteilung der Wirksamkeit des Black-Backings

Die wie im Abschnitt "Herstellung der holografischen Medien" beschrieben hergestellten Medien wurden anschließend mittels einer Messanordnung gemäß Fig. 5 wie folgt auf ihre holografischen Eigenschaften geprüft:

> Der Strahl eines Helium-Neon Lasers (Melles Griot 25-LHP-928-249, Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die λ/2 Plättchen wurden die Leistung des Referenzstrahls auf 0.5 mW und die Leistung des Signalstrahls auf 0.5 mW eingestellt. Die Leistungen wurden mit den Halbleiterdetektoren (D) bei ausgebauter Probe bestimmt. Der Einfallswinkel ($\alpha_0$) des Referenzstrahls beträgt -26.8°, der Einfallswinkel ($\beta_0$) des Signalstrahls beträgt 26.8°. Die Winkel werden ausgehend von der Probennormale zur Strahlrichtung gemessen. Gemäß Figur 5 hat daher $\alpha_0$ ein negatives Vorzeichen und $\beta_0$ ein positives Vorzeichen.

Am Ort der Probe (Medium) erzeugte das Interferenzfeld der zwei überlappenden Strahlen ein Gitter heller und dunkler Streifen die parallel zur Winkelhalbierenden der zwei auf die Probe einfallenden Strahlen liegen (Transmissionshologramm). Der Streifenabstand A, auch Gitterperiode genannt, im Medium beträgt ~ 702 nm (der Brechungsindex des Mediums zu ~1.504 angenommen).

Figur 5 zeigt den holografischen Versuchsaufbau, mit dem die Beugungseffizienz (DE) der Medien gemessen wurde.

Es wurden auf folgende Weise Hologramme in das Medium geschrieben:

- Beide Shutter (S) sind für die Belichtungszeit *t* geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung ($\Omega$ = 0) des Drehtisches ergibt sich dann, wenn beim Schreiben des Hologramms der Einfallswinkel des Referenz- und des Signalstrahls betragsmäßig gleich sind also $\alpha_0$ = -26.8° und $\beta_0$ = 26.8° gilt. Allgemein gilt für das Interferenzfeld beim Schreiben ("recording") eines symmetrischen Transmissionshologramms ($\alpha_0 = -\beta_0$):

$$\alpha_0 = \theta_0$$

$\theta_0$ ist der Halbwinkel im Laborsystem außerhalb des Mediums. In diesem Fall gilt also $\theta_0$ = -26.8°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$, des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die zentrale Beugungseffizienz (DE = $\eta_0$) des Hologramms, wurde bei $\Omega$ = 0 ermittelt.

Der Brechungsindexkontrast $\Delta n$ und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve angepasst. Das Auswerteverfahren wird im Folgenden beschrieben:

Für die Braggkurve $\eta(\Omega)$ eines Transmissionshologramms gilt nach Kogelnik:

$$\eta = \frac{\sin^2\left(\sqrt{\nu^2 + \xi^2}\right)}{1 + \frac{\xi^2}{\nu^2}}$$

mit:

$$\nu = \frac{\pi \cdot \Delta n \cdot d}{\lambda \cdot \sqrt{|c_s \cdot c_r|}}$$

$$\xi = -\frac{d}{2 \cdot c_s} \cdot DP$$

$$c_s = \cos(\vartheta)$$
$$c_r = \cos(\vartheta)$$
$$DP = \frac{\pi}{\Lambda} \cdot \left(-2 \cdot \sin(\vartheta) - \frac{\lambda}{n \cdot \Lambda}\right)$$

$$\Lambda = -\frac{\lambda}{2 \cdot n \cdot \sin(\alpha)}$$

Beim Auslesen des Hologramms ("reconstruction") gilt wie analog oben dargestellt:

$$\vartheta_0 = \theta_0 + \Omega$$

$$\sin(\vartheta_0) = n \cdot \sin(\vartheta)$$

An der Bragg-Bedingung ist das "Dephasing" *DP* = 0. Und es folgt entsprechend:

$$\alpha_0 = \theta_0$$

$$\sin(\alpha_0) = n \cdot \sin(\alpha)$$

$\nu$ ist die Gitterstärke und $\xi$ ist der Detuning Parameter des Brechungsindexgitters das geschrieben wurde. n ist der mittlere Brechungsindex des Photopolymers und wurde zu 1.504 gesetzt. $\lambda$ ist die Wellenlänge des Laserlichts im Vakuum.

Die zentrale Beugungseffizienz (DE = $\eta_0$) ergibt sich dann für $\xi$ = 0 zu:

$$DE = \sin^2(\nu) = \sin^2\left(\frac{\pi \cdot \Delta n \cdot d}{\lambda \cdot \cos(\alpha)}\right)$$

Die Messdaten der Beugungseffizienz und die theoretische Braggkurve werden wie in Fig. 6 gezeigt gegen den Drehwinkel $\Omega$ aufgetragen.

Da DE bekannt ist wird die Form der theoretischen Braggkurve nach Kogelnik nur noch durch die Dicke d der Photopolymerschicht bestimmt. $\Delta$n wird über DE für gegebene Dicke d so nachkorrigiert, dass Messung und Theorie von DE immer übereinstimmen. d wird nun solange angepasst bis die Winkelpositionen der ersten Nebenminima und die Höhen der ersten Nebenmaxima der theoretischen Braggkurve mit den Winkelpositionen der ersten Nebenminima und den Höhen der ersten Nebenmaxima der gemessenen Braggkurve übereinstimmen.

Fig. 6 zeigt die Darstellung der Braggkurve η nach der Coupled Wave Theorie (durchgezogene Linie) und des gemessenen Beugungswirkungsgrades (Kreise), sowie die Intensität des transmittierten Lichtes gegen den Drehwinkel Ω einmal für den Fall das keine Schwarzschicht verwendet wurde. Fig. 7 zeigt dieselbe Darstellung wie Fig. 6 bei Verwendung einer Schwarzschicht.

Fig. 8 zeigt den Probenaufbau und die verwendete Probenorientierung im Falle des erfindungsgemäßen Schichtaufbaus 100 und eines Vergleichsaufbaus 400 ohne Schwarzschicht. Der erfindungsgemäße Schichtaufbau 100 sowie auch der Vergleichsaufbau umfassen eine auf eine Trägerfolie 102 aufgebrachte Photopolymerschicht 101 und ist mit der Oberfläche der Trägerfolie 102 den einfallenden Laserstrahlen zugewandt. Der Photopolymerfilm (Substrat mit aufgebrachter Photopolymerschicht) ist auf eine 1 mm dicke Glasplatte 104 laminiert. Bei dem erfindungsgemäßen Schichtaufbau 100 ist ferner die Schwarzschicht 103 auf die den einfallenden Laserstrahlen abgewandte Seite der Glasplatte 104 laminiert. Dieser Aufbau wird zum oben beschriebenen Schreiben des Hologramms verwendet. Zum Auslesen wird entweder die Schwarzschicht 103 entfernt oder der belichtete Photopolymerfilm auf ein Glassubstrat ohne die Schwarzschicht 103 um laminiert.

Wenn keine Schwarzschicht verwendet wird, zeigt der Beugungswirkungsgrad und die transmittierte Intensität starke Modulationen in Abhängigkeit vom Drehwinkel Ω, die von einem Betrachter als Helligkeitsschwankungen des Hologramms wahrgenommen werden. Wird eine Schwarzschicht verwendet, verschwinden die Modulation völlig und ein Betrachter nimmt eine homogene Helligkeit des Hologramms wahr.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms Δn in den Sättigungswert übergeht. Die mittlere Energiedosis E ergibt sich wie folgt aus den Leistungen der zwei den Winkeln $\alpha_0$ und $\beta_0$ zugeordneten Teilstrahlen (Referenzstrahl mit $P_r$ = 0.50 mW und Signalstrahl mit $P_s$ = 0.50 mW), der Belichtungszeit t und dem Durchmesser der Irisblende (0.4 cm):

$$E\,(\mathrm{mJ/cm^2}) = \frac{2 \cdot [P_r + P_s] \cdot t\,(\mathrm{s})}{\pi \cdot 0.4^2\ \mathrm{cm}^2}$$

## Patentansprüche

1. Schichtaufbau (100, 200, 300) mit einer Substratschicht (104) und mindestens einem Verbund aus einer Trägerfolie (102) und einer auf der Trägerfolie angeordneten Aufzeichnungsschicht (101), wobei der Schichtaufbau (100, 200, 300) eine vom Verbund aus Trägerfolie (102) und Aufzeichnungsschicht (101) entfernbare Schwarzschicht (103) umfasst, **dadurch gekennzeichnet, dass** die Aufzeichnungsschicht (101) ein Photopolymer, hergestellt aus einer Photopolymer-Formulierung umfassend eine Polyisocyanat-Komponente, eine isocyanatreaktive Komponente, wenigstens ein Schreibmonomer und wenigstens einen Photoinitiator, ist.

2. Schichtaufbau nach Anspruch 1, **dadurch gekennzeichnet, dass** die Aufzeichnungsschicht (101) geeignet ist, um darin Hologramme auszubilden und/ oder dass in der Aufzeichnungsschicht (101) wenigstens ein Hologramm ausgebildet ist, wobei das Hologramm insbesondere ein Volumenhologramm ist, ganz besonders bevorzugt ein Transmissionshologramm.

3. Schichtaufbau nach Anspruch 1 oder 2, **dadurch gekennzeichnet, dass** die Schwarzschicht (103) auf einer Seite der Substratschicht (104) und der Verbund aus Trägerfolie (102) und Aufzeichnungsschicht (101) auf der anderen Seite der Substratschicht (104) mit der Aufzeichnungsschicht (101) zur Substratschicht (104) hin angeordnet ist, wobei die Schichten insbesondere in der Reihenfolge Schwarzschicht (103), Substratschicht (104), Aufzeichnungsschicht (101) und Trägerfolie (102) unmittelbar aufeinander angeordnet sind.

4. Schichtaufbau nach Anspruch 1 oder 2, **dadurch gekennzeichnet, dass** die Schwarzschicht (103) auf der der Substratschicht (104) abgewandten Fläche der Trägerfolie (102) und die Aufzeichnungsschicht (101) auf der der Substratschicht (104) zugewandten Fläche der Trägerfolie (102) angeordnet ist, wobei die Schichten insbesondere in der Reihenfolge Substratschicht (104), Aufzeichnungsschicht (101), Trägerfolie (102) und Schwarzschicht (103) unmittelbar aufeinander angeordnet sind.

5. Schichtaufbau nach Anspruch 1 oder 2, **dadurch gekennzeichnet, dass** die Schwarzschicht (103) auf der der Substratschicht (104) abgewandten Fläche der Aufzeichnungsschicht (101) und die Trägerfolie (102) auf der der

Substratschicht (104) zugewandten Fläche der Aufzeichnungsschicht (101) angeordnet ist, wobei die Schichten insbesondere in der Reihenfolge Substratschicht (104), Trägerfolie (102), Aufzeichnungsschicht(101) und Schwarzschicht (103) unmittelbar aufeinander angeordnet sind.

6. Schichtaufbau nach einem der vorstehenden Ansprüche, **dadurch gekennzeichnet, dass** die Substratschicht (104) transparent ist und insbesondere ausgewählt ist aus Glas und thermoplastischen Kunststoffen mit einer hemisphärischen Transmission gemäß ASTM E 1348 nach D65/10° von > 80%, bevorzugt > 89%, sowie einem Haze gemäß ASTM D 1003 von < 0,5%, bevorzugt < 0,1%.

7. Schichtaufbau nach einem der vorstehenden Ansprüche, **dadurch gekennzeichnet, dass** die Schwarzschicht (103) ausgewählt ist aus schwarzen Klebebändern, schwarzen Kaschierfolien, schwarz gefärbten Schmelzklebstoffen, schwarz gefärbten Schmelzklebstofffolien und Schwarzlacken.

8. Schichtaufbau nach einem der vorstehenden Ansprüche, **dadurch gekennzeichnet, dass** die Schwarzschicht (103) frei von lichtstreuenden Partikeln ist.

9. Schichtaufbau nach einem der vorstehenden Ansprüche, **dadurch gekennzeichnet, dass** die Schwarzschicht (103) einen Absorptionsquotienten für die Reflexionsmessung von $Q \leq 0{,}70$ aufweist, wobei der Absorptionsquotient Q das Verhältnis der Reflektion einer Glasplatte mit Schwarzschicht (103) im Vergleich zu derselben Glasplatte ohne Schwarzschicht (103) bei Beleuchtung von der transparenten Glasseite aus mit einer Wellenlänge von 532 nm beschreibt, bevorzugt $Q \leq 0{,}55$ und besonders bevorzugt $Q \leq 0{,}52$.

10. Schichtaufbau nach einem der vorstehenden Ansprüche, **dadurch gekennzeichnet, dass** die Trägerfolie (102) ausgewählt ist aus transparenten Folien.

11. Schichtaufbau nach einem der vorstehenden Ansprüche, **dadurch gekennzeichnet, dass** die Trägerfolie (102) sowie unabhängig hiervon die Folie des schwarzen Klebebandes ausgewählt ist aus Folien auf Basis von Polycarbonat, Polyethylenterephthalat, Polybutylenterephthalat, Polyethylen, Polypropylen, Celluloseacetate, Cellulosehydrat, Cellulosenitrat, Cycloolefinpolymere, Polystyrol, Polyepoxide, Polysulfon, Cellulosetriacetat, Polyamid, Polymethylmethacrylat, Polyvinylchlorid, Polyvinylbutyral, Polydicyclopentadien, sowie deren Mischungen und/ oder Laminaten, insbesondere aus Folien auf Basis von Polycarbonat, Polyethylenterephthalat, Polyamid, Cellulosetriacetat sowie deren Mischungen und/ oder Laminaten.

12. Verfahren zur Erzeugung eines Schichtaufbaus (100, 200, 300) gemäß einem der Ansprüche 1 bis 11, umfassend die Schritte:

   - Bereitstellen der Substratschicht (104),
   - Erzeugung des Verbundes durch Aufbringen der Aufzeichnungsschicht (101) auf die Trägerfolie (102),

   **dadurch gekennzeichnet,**
   **dass** die Schwarzschicht (103) auf der dem Verbund abgewandten Fläche der Substratschicht (104) und die Aufzeichnungsschicht (101) auf der der Substratschicht (104) zugewandten Fläche der Trägerfolie (102) angeordnet wird, wobei die Schichten insbesondere in der Reihenfolge Schwarzschicht (103), Substratschicht (104), Aufzeichnungsschicht (101) und Trägerfolie (102) unmittelbar aufeinander angeordnet werden, oder
   **dass** die Schwarzschicht (103) auf der der Substratschicht (104) abgewandten Fläche der Trägerfolie (102) und die Aufzeichnungsschicht (101) auf der der Substratschicht (104) zugewandten Fläche der Trägerfolie (102) angeordnet wird, wobei die Schichten insbesondere in der Reihenfolge Substratschicht (104), Aufzeichnungsschicht (101), Trägerfolie (102) und Schwarzschicht (103) unmittelbar aufeinander angeordnet werden, oder
   **dass** die Schwarzschicht (103) auf der der Substratschicht (104) abgewandten Fläche der Aufzeichnungsschicht (101) und die Trägerfolie (102) auf der der Substratschicht (104) zugewandten Fläche der Aufzeichnungsschicht (101) angeordnet ist, wobei die Schichten insbesondere in der Reihenfolge Substratschicht (104), Trägerfolie (102), Aufzeichnungsschicht(101)und Schwarzschicht (103) unmittelbar aufeinander angeordnet sind.

13. Verfahren nach Anspruch 13, **dadurch gekennzeichnet, dass** in der Aufzeichnungsschicht (101) durch Belichtung zumindest ein Hologramm erzeugt wird, insbesondere ein Volumenhologramm, wobei vorzugsweise nach der Erzeugung des Hologramms der Verbund aus Aufzeichnungsschicht (101) und Trägerfolie (102) von der Substratschicht (104) abgelöst und die Schwarzschicht (103) entfernt wird.

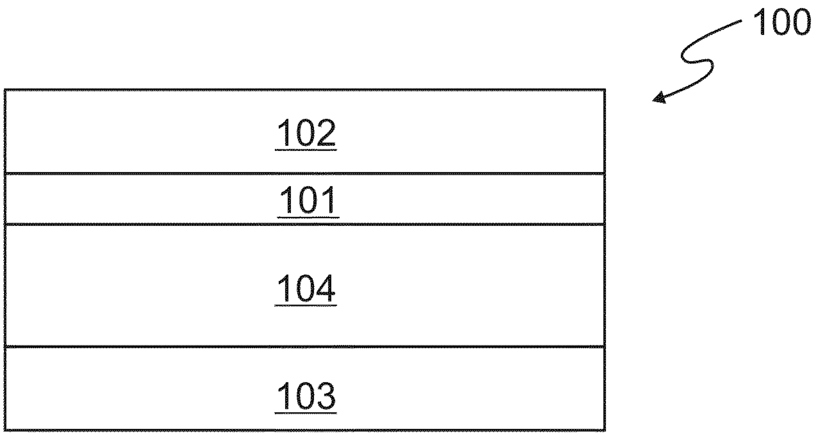


Fig. 1

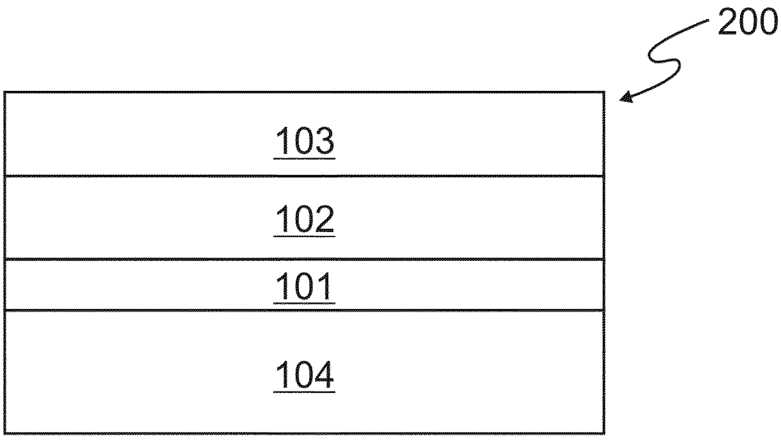


Fig. 2

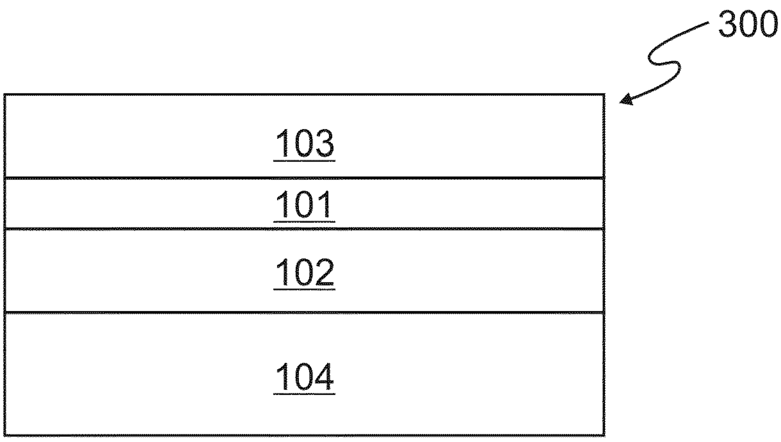


Fig. 3

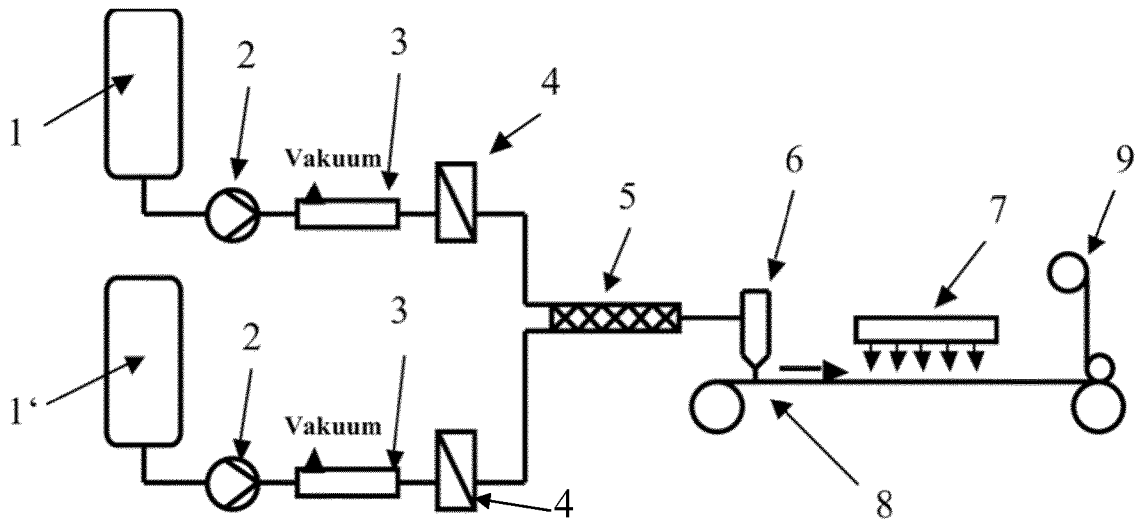
1
2
3
4
Vakuum
5
6
7
9
1'
2
3
Vakuum
4
8

Fig. 4

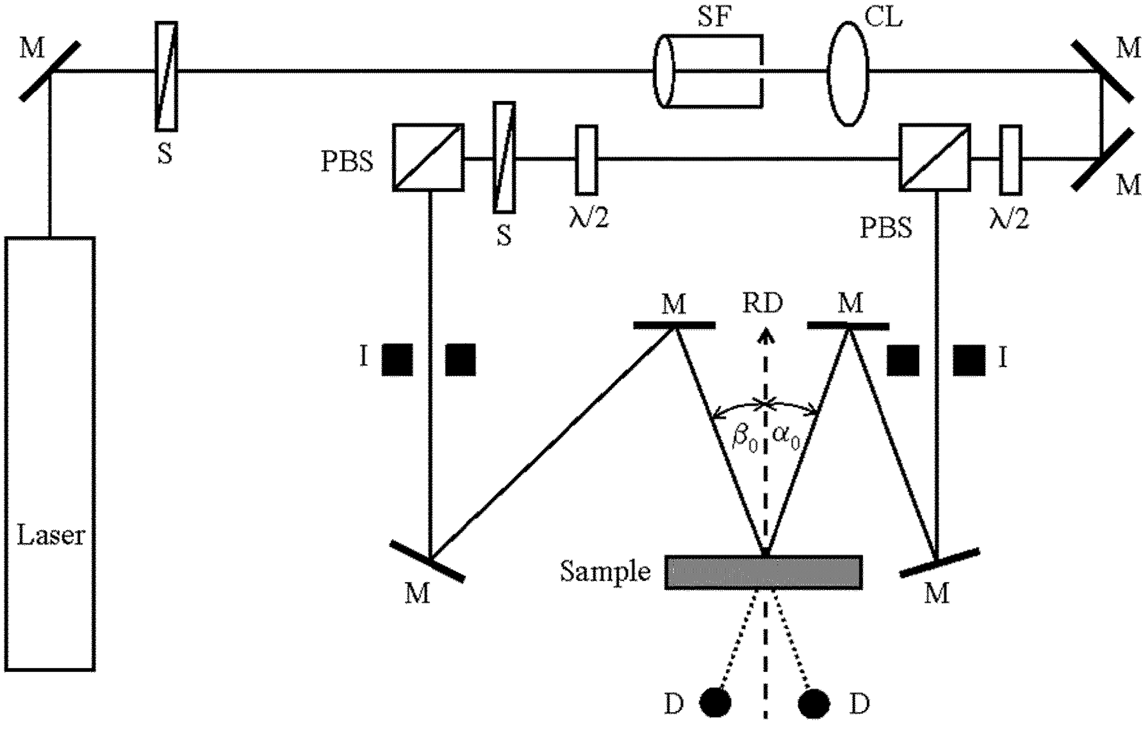
M
S
SF
CL
M
PBS
S
λ/2
PBS
λ/2
M
M
RD
M
I
I
$\beta_0$
$\alpha_0$
Laser
Sample
M
M
D
D

Fig. 5

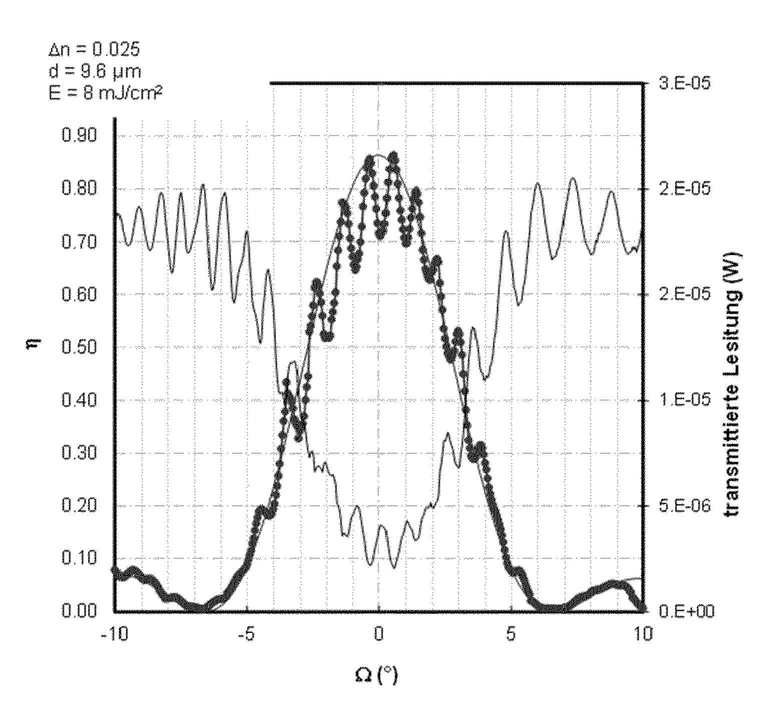
Δn = 0.025
d = 9.6 µm
E = 8 mJ/cm²
η
0.90
0.80
0.70
0.60
0.50
0.40
0.30
0.20
0.10
0.00
3.E-05
2.E-05
2.E-05
1.E-05
5.E-06
0.E+00
transmittierte Lesitung (W)
-10
-5
0
5
10
Ω (°)

Fig. 6

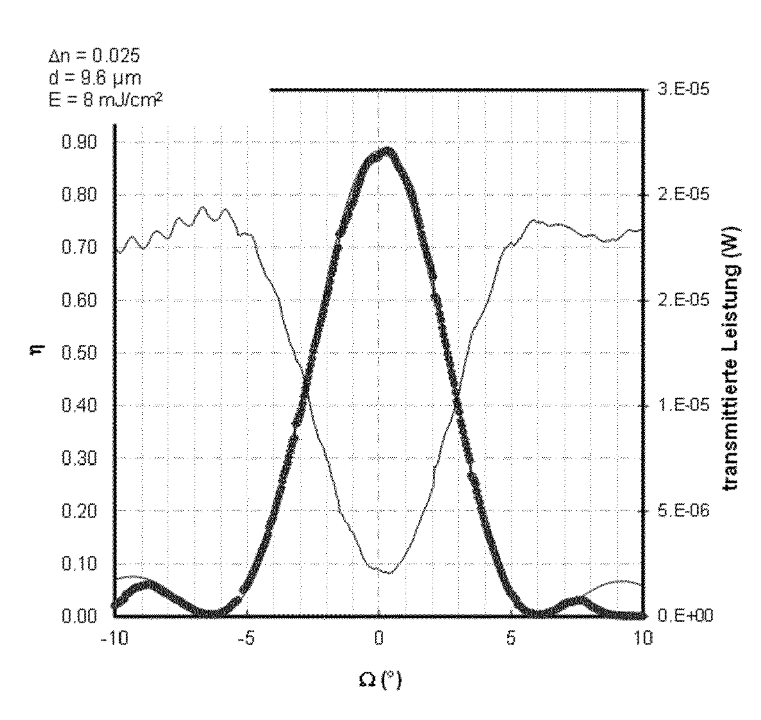
Δn = 0.025
d = 9.6 µm
E = 8 mJ/cm²
η
0.90
0.80
0.70
0.60
0.50
0.40
0.30
0.20
0.10
0.00
3.E-05
2.E-05
2.E-05
1.E-05
5.E-06
0.E+00
transmittierte Leistung (W)
-10
-5
0
5
10
Ω (°)

Fig. 7

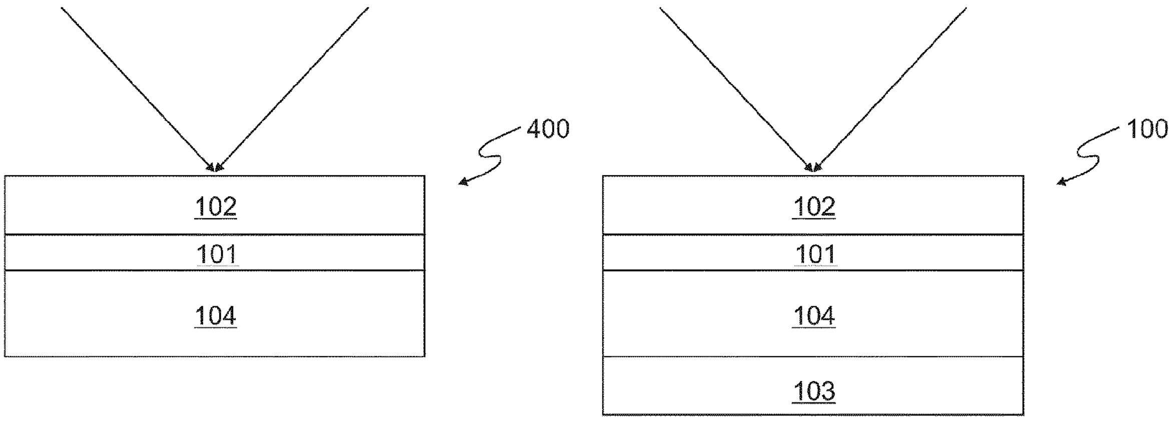


Fig. 8

Europäisches Patentamt
European Patent Office
Office européen des brevets

# EUROPÄISCHER RECHERCHENBERICHT

Nummer der Anmeldung
EP 14 16 7146

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 266 166 B1 (KATSUMATA MASAKI [JP] ET AL) 24. Juli 2001 (2001-07-24)<br>* das ganze Dokument * | 1-13 | INV.<br>G03H1/02<br>G02B5/32<br>B32B7/06<br>G03H1/04<br>G03C1/825 |
| X | US 6 878 493 B1 (UEDA KENJI [JP] ET AL) 12. April 2005 (2005-04-12)<br>* Abbildungen 1-9 *<br>* Spalte 7, Zeile 15 - Spalte 14, Zeile 53 * | 1-13 | |
| X | EP 0 726 142 A2 (DAINIPPON PRINTING CO LTD [JP]) 14. August 1996 (1996-08-14)<br>* das ganze Dokument * | 1-13 | |
| A | EP 0 536 763 A1 (NIPPON DENSO CO [JP] DENSO CORP [JP])<br>14. April 1993 (1993-04-14)<br>* Zusammenfassung; Abbildungen 1, 8, 10, 11 *<br>* Seite 3, Zeile 1 - Zeile 16 * | 7-9 | |
| | | | RECHERCHIERTE SACHGEBIETE (IPC) |
| A,D | WO 2011/054797 A1 (BAYER MATERIALSCIENCE AG [DE]; WEISER MARC-STEPHAN [DE]; BRUDER FRIEDR) 12. Mai 2011 (2011-05-12)<br>* das ganze Dokument * | 1,12 | G03H<br>G02B<br>B32B<br>C08F<br>G03F<br>C08G<br>G11B<br>G03C |
| A,D | WO 2011/067057 A1 (BAYER MATERIALSCIENCE AG [DE]; HOENEL DENNIS [DE]; WEISER MARC-STEPHAN) 9. Juni 2011 (2011-06-09)<br>* das ganze Dokument * | 1,12 | |

Der vorliegende Recherchenbericht wurde für alle Patentansprüche erstellt

1

| Recherchenort | Abschlußdatum der Recherche | Prüfer |
|---|---|---|
| München | 8. Juli 2014 | Lutz, Christoph |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 14 16 7146

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-07-2014

| Im Recherchenbericht angeführtes Patentdokument | Datum der Veröffentlichung | Mitglied(er) der Patentfamilie | Datum der Veröffentlichung |
|---|---|---|---|
| US 6266166 B1 | 24-07-2001 | KEINE | |
| US 6878493 B1 | 12-04-2005 | JP 4404282 B2 | 27-01-2010 |
| | | JP 2000338844 A | 08-12-2000 |
| | | US 6878493 B1 | 12-04-2005 |
| EP 0726142 A2 | 14-08-1996 | DE 69627913 D1 | 12-06-2003 |
| | | DE 69627913 T2 | 06-05-2004 |
| | | EP 0726142 A2 | 14-08-1996 |
| | | JP 3731759 B2 | 05-01-2006 |
| | | JP H08220976 A | 30-08-1996 |
| | | US 5755919 A | 26-05-1998 |
| | | US 5993600 A | 30-11-1999 |
| EP 0536763 A1 | 14-04-1993 | DE 69228644 D1 | 22-04-1999 |
| | | DE 69228644 T2 | 18-11-1999 |
| | | EP 0536763 A1 | 14-04-1993 |
| | | US 5313317 A | 17-05-1994 |
| | | US 5604611 A | 18-02-1997 |
| WO 2011054797 A1 | 12-05-2011 | CN 102667935 A | 12-09-2012 |
| | | EP 2497083 A1 | 12-09-2012 |
| | | JP 2013510204 A | 21-03-2013 |
| | | KR 20130006421 A | 16-01-2013 |
| | | TW 201133139 A | 01-10-2011 |
| | | US 2012231377 A1 | 13-09-2012 |
| | | WO 2011054797 A1 | 12-05-2011 |
| WO 2011067057 A1 | 09-06-2011 | CN 102870157 A | 09-01-2013 |
| | | EP 2497085 A1 | 12-09-2012 |
| | | ES 2453267 T3 | 07-04-2014 |
| | | JP 2013510336 A | 21-03-2013 |
| | | KR 20120101642 A | 14-09-2012 |
| | | PT 2497085 E | 27-03-2014 |
| | | RU 2012122585 A | 10-12-2013 |
| | | TW 201132662 A | 01-10-2011 |
| | | US 2012214089 A1 | 23-08-2012 |
| | | WO 2011067057 A1 | 09-06-2011 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 20120038959 A
- US 20060176533 A
- US 4942112 A
- US 5759721 A
- EP 1510862 A
- EP 1231511 A
- EP 211615 A
- WO 2003036389 A
- US 2002142227 A
- WO 2010037515 A
- US 5985490 A
- WO 2011054797 A
- WO 2011067057 A
- EP 2172503 A1
- EP 0223587 A
- EP 2011069389 W


### In der Beschreibung aufgeführte Nicht-Patentliteratur


- **GRAHAM SAXBY.** Practical Holography. IOP Publishing, 2003
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- Chemistry & Technology of UV & EB Formulations For Coatings, Inks & Paints. SITA Technology, 1991, vol. 3, 61-328
- **H. BERNETH.** Ullmann's Encyclopedia of Industrial Chemistry, Azine Dyes. Wiley-VCH Verlag, 2008
- **H. BERNETH.** Ullmann's Encyclopedia of Industrial Chemistry, Methine Dyes and Pigments. Wiley-VCH Verlag, 2008
- **T. GESSNER ; U. MAYER.** Ullmann's Encyclopedia of Industrial Chemistry, Triarylmethane and Diarylmethane Dyes. Wiley-VCH Verlag, 2000
- Virtual Computational Chemistry Laboratory. *J. Comput. Aid. Mol. Des.,* 2005, vol. 19, 453, http://www.vcclab.org
- Weitere Informationen. **MÜLLER ; RATH.** Formulierung von Kleb- und Dichtrohstoffen. 2009
- **H. KOGELNIK.** *The Bell System Technical Journal,* November 1969, vol. 48 (9), 2909, , 2947